# EUROPEAN PATENT APPLICATION

(11) **EP 4 822 786 A1**
(43) Date of publication of application: **14.10.2026**
(21) Application number: 25745393.6
(22) Date of filing: 24.01.2025
(51) Int. Cl.: H01M 4/66, H01M 4/13, H01M 10/052, C08G 61/12

(54) **CURRENT COLLECTOR**

(30) Priority: 26.01.2024 KR 20240012285; 13.09.2024 KR 20240126161; 13.09.2024 KR 20240126162; 13.09.2024 KR 20240126164
(71) Applicant: LG Chem, Ltd., Seoul 07336 (KR); LG Energy Solution, Ltd., Seoul 07335 (KR)
(72) Inventor: YANG, Hee Myeong, Daejeon 34122 (KR); SONG, In Taek, Daejeon 34122 (KR); KANG, Joon Koo, Daejeon 34122 (KR); KIM, Ki Hwan, Daejeon 34122 (KR); PARK, Eun Kyoung, Daejeon 34122 (KR); CHOI, Hyun Ju, Daejeon 34122 (KR); KOH, Jong Kwan, Daejeon 34122 (KR); CHO, Woo Hyung, Daejeon 34122 (KR); LEE, Yu Mi, Daejeon 34122 (KR); LEE, Seok Kyeong, Daejeon 34122 (KR)
(74) Representative: Plasseraud IP
(86) International application number: PCT/KR2025/001481
(87) International publication number: WO 2025/159571

(57) **Abstract**

The present specification discloses a current collector and a use thereof. The current collector comprises a polymer layer exhibiting a so-called PTC (Positive Temperature Coefficient) effect at a required level at a required time, whereby it can be suitably applied in applications where stability problems due to abnormally high heat and/or flame are caused. In the polymer layer of the current collector, the PTC effect can rapidly appear at a required time. The present specification also discloses a use of the current collector.

## Description

### Technical Field

This application claims the benefit of priority based on Korean Patent Application No. 10-2024-0012285 dated January 26, 2024, and Korean Patent Application Nos. 10-2024-0126162, 10-2024-0126161, and 10-2024-0126164 dated September 13, 2024, all disclosures of which are incorporated herein by reference.

The present specification discloses a current collector and a use thereof.

### Background Art

An energy storage technology has expanded application areas to mobile phones, tablet and notebook PCs, or electric vehicles, and the like.

As the data processing speed of mobile devices such as mobile phones or tablets increases and their used hours also increase, the development of secondary batteries with high energy density and operating potential, long cycle life, and low self-discharge rate is in progress.

As major developed countries suppress production of cars driven by internal combustion engines to alleviate global warming and air pollution, major automobile manufacturers also develop various electric vehicles, and thus the importance of secondary batteries having high energy density, high discharge voltage, and output stability increases as driving sources thereof.

According to the above trend, the occurrence frequency of ignition or explosion accidents due to overcharging, high-temperature exposure or outer shocks, and the like in devices or automobiles using secondary batteries as an energy source also increases.

As a main cause of such accidents, a short phenomenon, in which a positive electrode and a negative electrode inside an electrode assembly come into direct contact with each other mainly due to external stimuli, is known. When the secondary battery is overcharged or exposed to high temperatures or external stimuli, the short phenomenon can occur by the separator shrinkage due to the internal temperature increase of the secondary battery, or the internal structure destruction of the secondary battery due to outer shocks, and the like.

When the short phenomenon occurs, migration of lithium ions and electrons is concentrated through the region where the positive electrode and the negative electrode are in direct contact with each other, so that internal heat generation can be promoted. Accordingly, it is known that as gas or the like is generated inside the battery, the volume expands, and the risk of ignition increases.

### Disclosure

### Technical Problem

The present specification discloses a current collector and its use. It is an object of the present specification to disclose a current collector applied with a polymer layer capable of securing stability in applications where stability problems due to abnormally high heat and/or flame are caused by rapidly exhibiting a so-called PTC (Positive Temperature Coefficient) effect at a required level at a required time. It is another object of the present specification to disclose a use of the current collector.

### Technical Solution

In this specification, the term room temperature means a natural temperature without artificially warming or cooling, which may mean, for example, any temperature within a range of 10°C to 30°C, or a temperature of about 23°C, about 25°C, or about 27°C or so.

Among physical properties mentioned in this specification, the physical property affected by the measurement temperature is a physical property measured at the room temperature, unless otherwise specified.

The unit of the temperature mentioned in this specification is Celsius (°C), unless otherwise specified.

In this specification, the term normal pressure means a natural pressure without artificially pressurizing or depressurizing, which may mean a pressure within a range of about 730 mmHg to 790 mmHg or so.

Among physical properties mentioned in this specification, the physical property affected by the measurement pressure is a physical property measured at normal pressure, unless otherwise specified.

Among physical properties mentioned in this specification, the physical property affected by the measurement humidity is a physical property measured at humidity without artificial adjustment in the room temperature and normal pressure states, unless otherwise specified.

In this specification, the term normal state means a normal operating state (e.g., a normal charging or discharging state of a secondary battery) and/or a storage state of an electrical/electronic device such as a secondary battery.

In this specification, the term abnormal state means a state where abnormal heating, ignition, and/or explosion occurs in an electrical/electronic device such as secondary batteries, or the risk of the abnormal heating, ignition, and/or explosion is increased. For example, a state where abnormal heating, ignition, or explosion occurs due to a short circuit phenomenon in a secondary battery, or a dangerous state where the possibility of the heating, ignition, or explosion is increased may be the abnormal state.

This specification discloses a current collector.

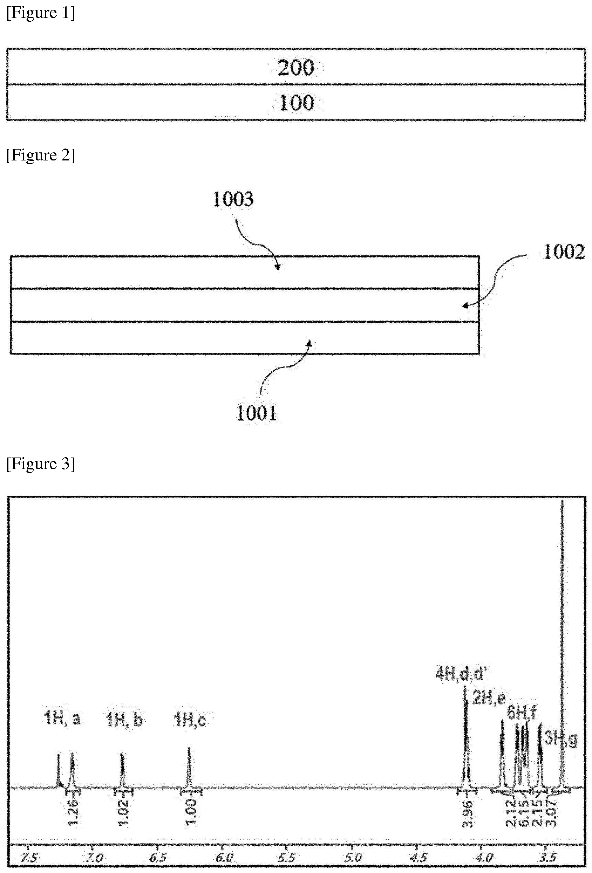

The current collector may comprise a current collector body and a polymer layer formed on the current collector body. The current collector may be, for example, an electrode current collector used to form an electrode. For example, the electrode formed using the current collector may comprise the current collector body and an active material layer formed on the polymer layer of the current collector body. Figure 1 is a cross-sectional diagram of a current collector comprising a current collector body (100) and a polymer layer (200), and Figure 2 is a cross-sectional schematic diagram showing an electrode in which an active material layer (1003) is formed on a polymer layer (1002) of the current collector body (1001).

As in the diagrams, in the current collector or electrode, the current collector body (100) and the polymer layer (200), and the polymer layer (200) and the active material layer (300) may also be in contact with each other. In some cases, other elements may also exist between the current collector body (100) and the polymer layer (200) or between the polymer layer (200) and the active material layer (300). In addition, although the diagrams illustrate a case where the active material layer (300) exists only on one side of the current collector body (100), the active material layer (300) may also exist on both sides of the current collector body (100). In this case, the polymer layer (200) may also exist in two layers between each of the active material layers (300) existing on both sides of the current collector body (100) and the current collector body (100), or may also exist in one layer between any one of the active material layers (300) existing on both sides and the current collector body (100).

The electrode formed by the current collector may be a negative electrode (anode) or a positive electrode (cathode) applied to a secondary battery.

The polymer layer exhibits a so-called PTC (positive temperature coefficient) effect. Therefore, the polymer layer may variably control migration of charges through the electrode according to the temperature.

By applying such a polymer layer, the electrode having the current collector can exhibit excellent electrical characteristics including low resistance in a normal state, and can secure stability through a resistance increase in an abnormal state.

In order that the polymer layer is applied to the electrode to exhibit the above effects, the tendency of the PTC effect exhibited by the polymer layer must be controlled. The PTC effect is an effect in which the resistance increases depending on changes in the temperature and/or pressure. In order that the electrode, to which the polymer layer having the PTC effect is applied, operates stably and secures stability in an abnormal state, electrical characteristics before the resistance increases due to the PTC effect, and a time point when the resistance increases due to the PTC effect, and the like must be adjusted.

For example, if the resistance of the polymer layer is excessively high in the normal state, it adversely affects the operation of the secondary battery. Furthermore, if the temperature at which the PTC effect is expressed is within the temperature range of the normal state, the performance of the secondary battery cannot be expressed appropriately.

The polymer layer has the PTC effect, the time point of the PTC effect expression is controlled, and stable electrical characteristics are maintained before the expression of the PTC effect.

For expression of such a PTC effect, it is possible to introduce a specific conductive polymer into the polymer layer. Also, by introducing a conductive material into the polymer layer and uniformly dispersing it therein, it is possible to appropriately maintain the oxidation potential or electrical characteristics as well. Furthermore, through proper application and dispersion of the conductive material, it is possible to ensure coating properties, and it is possible to form the uniform polymer layer.

For example, the current collector or the electrode comprising the same may exhibit desired results in an ARC (Accelerated Rate Calorimeter) test. The ARC test may be performed in the manner described in "Test Example 5" of this specification.

For example, in the current collector or the electrode comprising the same, a confirmation time point of a TR generation temperature in the ARC test may be adjusted. Here, the TR generation temperature is a time required until a time point when a temperature change rate becomes 1°C/min is confirmed in the ARC test performed in the manner described in "Test Example 5" of this specification.

In one example, the lower limit of the confirmation time point of the TR generation temperature may be30 hours, 31 hours, 32 hours, 33 hours, 34 hours, 35 hours, 36 hours, or 37 hours or so, and the upper limit thereof may be 50 hours, 45 hours, 40 hours, or 38 hours or so. The time point may be within a range of more than or equal to, or more than any lower limit arbitrarily selected from the above-listed lower limits; or within a range of less than or equal to, or less than any upper limit arbitrarily selected from the above-listed upper limits while being more than or equal to, or more than any lower limit arbitrarily selected from the above-listed lower limits. It means that the longer the confirmation time point of the TR generation temperature, the more effectively the current collector or the electrode comprising the same has coped with abnormalities in an abnormal state.

In one example, in the current collector or the electrode comprising the same, the TR generation temperature may be controlled to a certain level during the ARC test. For example, the lower limit of the TR generation temperature may be 60°C, 80°C, 100°C, 120°C, 140°C, 160°C, or 170°C or so, and the upper limit thereof may be 250°C, 200°C, or 180°C or so. The temperature may be within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits. It means that the longer the confirmation time point of the TR generation temperature, the more effectively the current collector or the electrode comprising the same has coped with abnormalities in an abnormal state.

In one example, in the current collector or the electrode comprising the same, the highest temperature confirmed in the ARC test may be controlled to a certain level. For example, the lower limit of the TR generation temperature may be 200°C, 250°C, 300°C, or 350°C or so, and the upper limit thereof may be 410°C, 400°C, 390°C, 380°C, 370°C, or 360°C or so. The temperature may be within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits. It means that the longer the confirmation time point of the TR generation temperature, the more effectively the current collector or the electrode comprising the same has coped with abnormalities in an abnormal state.

In one example, in the current collector or the electrode comprising the same, a metal migration ratio in an impact test may be adjusted within a predetermined range. The metal migration ratio is a ratio that metal (e.g., metal of a current collector of a counter electrode) migrates to the current collector or electrode via a separator in the impact test described in the "Test Example 6" section of this specification, which means a ratio of the migrated metal existing per unit area of 1 cm² of the surface of the current collector or electrode. In the "Test Example 6" section above, an electrode to which the current collector disclosed herein is applied is used as a positive electrode, and the positive electrode is laminated with a negative electrode via a separator and applied to the impact test, and then the area to which the metal of the negative electrode current collector (Cu foil) is migrated is evaluated, where the metal is Cu.

In one example, the lower limit of the ratio of the metal migration ratio may be 0 weight%, 0.0001 weight%, 0.0005 weight%, 0.001 weight%, 0.005 weight%, or 0.01 weight% or so, per unit area of 1 cm², and the upper limit thereof may be 0.35 weight%, 0.3 weight%, 0.25 weight%, 0.2 weight%, 0.15 weight%, 0.1 weight%, 0.09 weight%, 0.08 weight%, 0.07 weight%, 0.06 weight%, 0.05 weight%, 0.04 weight%, 0.03 weight%, 0.02 weight%, or 0.015 weight% or so. The ratio may be within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits. It means that the longer the confirmation time point of the TR generation temperature, the more effectively the current collector or the electrode comprising the same has coped with abnormalities in an abnormal state.

In one example, the current collector or the electrode comprising the same may exhibit a certain level of PTC onset temperature (Positive Temperature Coefficient onset temperature). The PTC onset temperature (Positive Temperature Coefficient onset temperature) is measured in the manner described in "Test Example 3" of this specification, which is the temperature at the time point when a significant increase in resistance occurs in the current collector or the electrode comprising the same.

In one example, the lower limit of the PTC onset temperature may be 70°C, 75°C, 80°C, 85°C, 90°C, 95°C, or 100°C or so, and the upper limit thereof may be 200°C, 180°C, 160°C, 140°C, 120°C, 110°C, or 100°C or so. The PTC onset temperature may be within a range of less than or equal to, or less than any upper limit arbitrarily selected from the above-listed upper limits while being more than or equal to, or more than any lower limit arbitrarily selected from the above-listed lower limits. The PTC onset temperature is, for example, a temperature range suitable when the current collector or the like has been applied to a secondary battery, which may be adjusted by controlling the composition (e.g., whether a conductive material is included) of the polymer layer and/or the composition (e.g., monomer composition) of the conductive polymer included in the polymer layer.

In one example, the current collector or the electrode comprising the same may exhibit a rapid resistance increase rate at a time point when the PTC onset temperature (Positive Temperature Coefficient on set temperature) is exceeded. The resistance increase rate is measured in the manner described in "Test Example 3" of this specification.

In one example, the lower limit of the resistance increase rate may be 400, 450, 500, 550, 600, 650, 700, 750, 800, 850, 900, 950, 1,000, or 1,100 or so, and the upper limit thereof may be 5,000, 4,500, 4,000, 3,500, 3,000, 2,500, 2,000, 1,500, 1,000, 800, or 600 or so. The upper limit of the resistance increase rate is ohms/sec. The resistance increase rate may be within a range of more than or equal to, or more than any arbitrarily selected lower limit from the above-listed lower limits; or within a range of less than or equal to, or less than any arbitrarily selected upper limit from the above-listed upper limits while being more than or equal to, or more than any arbitrarily selected lower limit from the above-listed lower limits. The rate is within a range capable of effectively responding to abnormal condition occurrence, which may be adjusted by controlling the composition (e.g., whether a conductive material is included) of the polymer layer and/or the composition (e.g., monomer composition) of the conductive polymer included in the polymer layer.

To exhibit the characteristics, they may be achieved through introduction of a polymer layer.

In one example, in the polymer layer exhibiting the characteristics, a 2θ peak may be identified within an appropriate range in an XRD (X-ray diffraction) analysis. The XRD analysis may be performed as described in "Test Example 1" section of this specification.

For example, the lower limit of the range in which the 2θ peak appears may be 3.4 degrees, 3.6 degrees, or 3.8 degrees or so, and the upper limit thereof may be 5 degrees, 4.8 degrees, 4.6 degrees, 4.4 degrees, 4.2 degrees, 4.0 degrees, or 3.9 degrees or so. The range may be a range of less than or equal to, or less than any upper limit arbitrarily selected from the above-listed upper limits while being more than or equal to, or more than any lower limit arbitrarily selected from the above-listed lower limits.

For example, in the polymer layer, a d-spacing of a (100) plane in the XRD (X-ray diffraction) analysis may be within a predetermined range. For example, the lower limit of the d-spacing may be 1.8 nm, 1.9 nm, 2.0 nm, 2.1 nm, 2.2 nm, or 2.3 nm or so, and the upper limit thereof may be 2.6 nm, 2.5 nm, 2.4 nm, or 2.3 nm or so. The range may be within a range of less than or equal to, or less than any upper limit arbitrarily selected from the above-listed upper limits while being more than or equal to, or more than any lower limit arbitrarily selected from the above-listed lower limits.

The position of the 2θ peak and/or the d-spacing in the XRD analysis represents the intermolecular distance of the polymer (conductive polymer) in the polymer layer. As the intermolecular distance decreases, electrical properties improve, but the expression effect of the PTC effect decreases; and as it increases, the temperature at the PTC onset time point decreases. Therefore, the desired effect can be achieved by controlling the intermolecular distance so that the characteristics are exhibited. Such an intermolecular distance can be achieved by controlling the composition of the conductive polymer.

As the current collector body, one commonly used as a current collector body for a positive or negative electrode may be used without any special limitation.

If the current collector body has conductivity without causing chemical changes in applied devices such as secondary batteries, the type, size, and shape thereof, and the like are not particularly limited. An example of a material that can be used as the current collector body may include copper, aluminum, stainless steel, nickel, titanium, or calcined carbon, and the like, or may be exemplified by a material, and the like in which the surface of copper, aluminum, or stainless steel is surface-treated with carbon, nickel, titanium, or silver, and the like. The current collector body may be in the form of a film, sheet, foil, net, porous body, foam, or nonwoven fabric, and the like, which comprises the above material. In some cases, a known surface treatment may also be performed on the surface of the current collector body to improve adhesive force to other layers such as a polymer layer or an active material layer.

Such a current collector body may typically have a thickness within a range of 3µm to 500 µm, but is not limited thereto.

The polymer layer is present on one or both sides of the current collector body.

The term "polymer layer" means a layer comprising a polymer. The lower limit of the polymer content in the polymer layer may be 30, 35, 40, 45, 50, 55, 60, 65, 70, 75, 80, 85, 90, or 95 or so, and the upper limit thereof may be 100, 95, 90, 85, 80, 75, 70, 65, 60, 55, or 50 or so. The content is the content of the polymer based on the total weight of the polymer layer, the unit of which is weight%. The content may be within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The polymer layer may not be a so-called electrode active material layer. The content of the electrode active material in the polymer layer may be controlled. For example, the upper limit of the content of the electrode active material in the polymer layer may be 10, 9, 8, 7, 6, 5, 4, 3, 2, 1, 0.5, 0.1, 0.05, 0.01, 0.005, or 0.001 or so, and the lower limit thereof may be 0. The content is the content of the electrode active material based on the total weight of the polymer layer, the unit of which is weight%. The content may be within a range of less than or equal to, or less than any upper limit arbitrarily selected from the above-listed upper limits; or within a range of more than or equal to, or more than the above-described lower limit while being less than or equal to, or less than any upper limit arbitrarily selected from the above-listed upper limits.

The polymer layer may comprise a conductive polymer. As is well known, a conductive polymer is a polymer that exhibits conductivity through conjugated systems of polymer chains and/or doping, and the like. For example, the conductive polymer is a polymer that exhibits low resistance in a doping state and high resistance in a de-doping state, which may be a polymer designed such that transition between these doping and de-doping states may occur rapidly at a necessary time point in response to temperatures and/or voltages.

The lower limit of the content of the conductive polymer in the polymer layer may be 30, 35, 40, 45, 50, 55, 60, 65, 70, 75, 80, 85, 90, or 95 or so, and the upper limit thereof may be 100, 95, 90, 85, 80, 75, 70, 65, 60, 55, or 50 or so. The content is the content of the conductive polymer based on the total weight of the polymer layer, the unit of which is weight%. The content may be within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The thickness of the polymer layer may be appropriately controlled depending on the purpose. For example, the lower limit of the thickness of the polymer layer may be 10 nm, 50 nm, 100 nm, 150 nm, 200 nm, 250 nm, 300 nm, 350 nm, 400 nm, 450 nm, 500 nm, 550 nm, or 600 nm or so, and the upper limit thereof may be 2 µm, 1.5 µm, 1 µm, 950 nm, 900 nm, 850 nm, 800 nm, 750 nm, 700 nm, 650 nm, 600 nm, 550 nm, 500 nm, 450 nm, or 400 nm or so. The thickness may be within a range of less than or equal to, or less than any upper limit arbitrarily selected from the above-listed upper limits while being more than or equal to, or more than any lower limit arbitrarily selected from the above-listed lower limits.

The conductive polymer included in the polymer layer may be a thiophene polymer (or polythiophene).

The term thiophene polymer or polythiophene means a polymer containing a thiophene monomer unit in a certain level or more.

For example, the lower limit of the ratio of the mole number of the thiophene monomer unit in the thiophene polymer may be 50 mol%, 55 mol%, 60 mol%, 65 mol%, 70 mol%, 75 mol%, 80 mol%, 85 mol%, 90 mol%, or 95 mol% or so, and the upper limit thereof may be 100 mol%, 95 mol%, 90 mol%, 80 mol%, 75 mol%, 70 mol%, 65 mol%, 60 mol%, 55 mol%, or 50 mol% or so. The ratio of the mole number of the thiophene monomer unit is the ratio (100xM_{T}/M) of the mole number (M_{T}) of all thiophene monomer units present in the thiophene polymer or the mole number (MT) of all thiophene monomers applied to prepare the thiophene polymer to the mole number (M) of all monomer units present in the thiophene polymer or the mole number (M) of all monomers applied to prepare the thiophene polymer. The ratio (100xM_{T}/M) of the thiophene monomer units may be within a range of more than or equal to, or more than any lower limit arbitrarily selected from the above-listed lower limits; or within a range of less than or equal to, or less than any upper limit arbitrarily selected from the above-listed upper limits while being more than or equal to, or more than any lower limit arbitrarily selected from the above-listed lower limits.

The term monomer unit means a form in which a certain monomer is polymerized and included in a polymer molecule (polymer). The term thiophene monomer is a thiophene-based monomer, which means a monomer containing a thiophene skeleton.

The conductive polymer may contain a long-chain hydrocarbon functional group or a monomer unit (hereinafter, referred to as unit A) having the long-chain hydrocarbon functional group. The unit A may be a thiophene monomer unit.

The term long-chain hydrocarbon functional group means a monovalent hydrocarbon group having a carbon number in a certain number or more, or a monovalent functional group containing the monovalent hydrocarbon group.

For example, the lower limit of the carbon number (i.e., the carbon number of the monovalent hydrocarbon group) present in the long-chain hydrocarbon functional group may be 3, 4, 5, 6, 7, 8, 9, 10, 11, or 12 or so, and the upper limit thereof may be 30, 29, 28, 27, 26, 25, 24, 23, 22, 21, 20, 19, 18, 17, 16, 15, 14, 13, 12, 11, 10, 9, 8, 7, 6, 5, or 4 or so. The carbon number may be within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The carbon number may be the total carbon number present in the long-chain hydrocarbon functional group, or the carbon number of the hydrocarbon chain of the linear structure of the functional group. That is, the monovalent hydrocarbon group present in the long-chain hydrocarbon functional group may have a linear or branched structure. When the monovalent hydrocarbon group has the linear structure, the carbon number of the linear structure may be within the range. When the monovalent hydrocarbon group has the branched structure, the carbon number constituting the longest linear chain in the relevant branched structure may be within the range. For example, if the branched structure is a 2-ethylhexyl group, the carbon number constituting the longest linear chain is 6.

An example of the long-chain hydrocarbon functional group may be exemplified by one or more selected from the group consisting of an alkyl group, an alkenyl group, an alkynyl group, an alkoxy group, an alkylcarbonyl group, and an alkylcarbonyloxy group. In an appropriate example, the long-chain hydrocarbon functional group may be an alkyl group and/or an alkoxy group.

The carbon number present in the alkyl group, the alkenyl group, the alkynyl group, the alkoxy group, the alkyl group of the alkylcarbonyl group, and the alkyl group of the alkylcarbonyloxy group may be in the range of the carbon number (i.e., the carbon number of the monovalent hydrocarbon group) present in the long-chain hydrocarbon functional group.

The alkyl group, the alkenyl group, the alkynyl group, the alkoxy group, the alkyl group of the alkylcarbonyl group, and the alkyl group of the alkylcarbonyloxy group may be a linear or branched structure. In the case of a branched chain, the carbon number constituting the longest linear chain in the relevant branched structure may be in the range.

The alkyl group, the alkenyl group, the alkynyl group, the alkoxy group, the alkylcarbonyl group, or the alkylcarbonyloxy group, which is the long-chain hydrocarbon functional group, may also be optionally substituted with one or more substituents.

The long-chain hydrocarbon functional group may exhibit enhanced vibration energy at an increased temperature. This enhanced vibration energy may affect the doping and de-doping state of the conductive polymer. The degree of the vibration energy and the temperature at which the vibration energy appears are affected by the carbon number and arrangement state of the long-chain hydrocarbon functional group. Therefore, by adjusting the carbon number and amount of the long-chain hydrocarbon functional group and adjusting the arrangement state by the manufacturing method to be described below, it is possible to secure the desired properties for the polymer layer. For example, at the same temperature, the vibration energy of a relatively long chain is greater than that of a relatively short chain. Therefore, by appropriately employing a long chain and a short chain as the long-chain hydrocarbon functional group, it is possible to provide a conductive polymer to meet the intended effect.

Furthermore, by appropriately adjusting the type and ratio of the long-chain hydrocarbon functional group, it is possible to adjust the above-described intermolecular distance to a desired level.

Incidentally, the long-chain hydrocarbon functional group can provide appropriate mobility to a monomer or a polymer during the polymerization process of the conductive polymer, and accordingly, can also improve the polymerization efficiency, and coating efficiency, and the like.

For example, the ratio of the mole number (M_{L}) of the long-chain hydrocarbon functional group or the mole number (M_{L}) of the monomer unit (unit A) having the functional group to the mole number (M) of the total monomer units of the conductive polymer may be adjusted. For example, the lower limit of the ratio may be 20 mol%, 25 mol%, 30 mol%, 35 mol%, 40 mol%, 45 mol%, 50 mol%, 55 mol%, 60 mol%, 65 mol%, 70 mol%, 75 mol%, 80 mol%, 85 mol%, or 95 mol% or so, and the upper limit thereof may be 95 mol%, 90 mol%, 85 mol%, 80 mol%, 75 mol%, 70 mol%, 65 mol%, or 60 mol% or so. The ratio is a ratio (100xM_{L}/M) of the mole number (M_{L}) of all long-chain hydrocarbon functional groups present in the conductive polymer or the mole number (M_{L}) of monomer units having the long-chain hydrocarbon functional group or the mole number (M_{L}) of monomers having all long-chain hydrocarbon functional groups applied to prepare the thiophene polymer to the mole number (M) of all monomer units present in the conductive polymer or the mole number (M) of all monomers applied to prepare the conductive polymer. The ratio may be within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The conductive polymer may include a first hydrocarbon functional group and a second hydrocarbon functional group.

The first hydrocarbon functional group is a functional group having a relatively large carbon number among the long-chain hydrocarbon functional groups. The lower limit of the carbon number of the first hydrocarbon functional group may be 10, 11, or 12 or so, and the upper limit thereof may also be 20, 19, 18, 17, 16, 15, 14, 13, 12, 11, or 10 or so. The carbon number of the first hydrocarbon functional group may be within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The second hydrocarbon functional group is a functional group having a relatively small carbon number among the long-chain hydrocarbon functional groups. The lower limit of the carbon number of the second hydrocarbon functional group may be 3, 4, 5, 6, 7, or 8 or so, and the upper limit thereof may also be 9, 8, 7, or 6 or so. The carbon number of the second hydrocarbon functional group may be within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The carbon number of each of the first and second hydrocarbon functional groups may be the carbon number of the hydrocarbon chain of the linear structure present in the hydrocarbon functional group. For example, the first and second hydrocarbon functional groups may each independently be one or more selected from the group consisting of an alkyl group, an alkenyl group, an alkynyl group, an alkoxy group, an alkylcarbonyl group, and an alkylcarbonyloxy group, and may be, in a suitable example, an alkyl group and/or an alkoxy group, where the carbon number may be the carbon number of the alkyl group, the alkenyl group, the alkynyl group, the alkoxy group, the alkyl group of the alkylcarbonyl group, and the alkyl group of the alkylcarbonyloxy group.

The alkyl group, the alkenyl group, the alkynyl group, the alkoxy group, the alkyl group of the alkylcarbonyl group, and the alkyl group of the alkylcarbonyloxy group may have a linear or branched structure, and in the case of the linear chain, the total carbon number may be in the range, and in the case of the branched chain, the carbon number constituting the longest linear chain in the branched structure may be in the range.

The carbon number of the long-chain hydrocarbon functional group is a functional group exhibiting enhanced vibration energy at an increased temperature, where the higher the carbon number at the same temperature, the higher the vibration energy. That is, the first hydrocarbon functional group exhibits higher vibration energy than the second hydrocarbon functional group at the same temperature, and the sum of the vibration energies of these two functional groups may optimize the properties of the conductive polymer that are difficult to precisely control with one functional group.

For example, the first hydrocarbon functional group exhibits enhanced vibration energy at an increased temperature, and the second hydrocarbon functional group dilutes the vibration energy by the first hydrocarbon functional group at the same temperature, whereby it is possible to precisely control the start temperature (onset point) of the de-doping of the conductive polymer according to the purpose.

Furthermore, the desired intermolecular distance can be achieved through adjustment of the ratio of the first and second hydrocarbon functional groups.

The ratio of the sum mole number of the first and second hydrocarbon functional groups or the sum mole number of the monomer units having the first hydrocarbon functional group and the monomer units having the second hydrocarbon functional group relative to the mole number (M) of the total monomer units of the conductive polymer may adjusted in the same range as the ratio 100xM_{L}/M as described above.

The lower limit of the ratio (M₂/M₁) of the mole number (M₂) of the second hydrocarbon functional group or the mole number (M₂) of the monomer units having the second hydrocarbon functional group to the mole number (M₁) of the first hydrocarbon functional group or the mole number (M₁) of the monomer units having the first hydrocarbon functional group may be 0.01, 0.05, 0.1, 0.5, 0.6, 0.7, 0.8, 0.9, 0.95, 1.0, 1.1, or 1.15 or so, and the upper limit thereof may be 100, 95, 90, 85, 80, 75, 70, 65, 60, 55, 50, 45, 40, 35, 30, 25, 20, 15, 10, 9, 8, 7, 6, 5, 4, 3, 2, 1.5, 1.3, 1, or 0.7 or so. The ratio may be within a range of more than or equal to, or more than any lower limit arbitrarily selected from the above-listed lower limits while being less than or equal to, or less than any upper limit arbitrarily selected from the above-listed upper limits. The ratio M₂/M₁ may be changed in consideration of the level of the desired vibrational energy and the design value of the polymer layer.

The conductive polymer may contain a polar functional group together with the long-chain hydrocarbon functional group. The monomer having the polar functional group may be a thiophene monomer.

The term polar functional group is a functional group containing one, or two or more polar atoms, for example, oxygen and/or nitrogen. An example of such a functional group includes a carboxyl group, a hydroxyl group, an amino group, a cyano group, a nitro group, an ether group, an alkoxy group, and/or a functional group of Formula 1 below, but is not limited thereto.

The alkoxy group may be, in one example, an alkoxy group with 1 to 20 carbon atoms, 1 to 16 carbon atoms, 1 to 12 carbon atoms, 1 to 8 carbon atoms or 1 to 4 carbon atoms. The alkoxy group may be linear, branched, or cyclic, and may be linear or branched, as appropriate. The alkoxy group may be optionally substituted with one or more substituents.

In one example, the polar functional group may be a functional group of Formula 1 below.

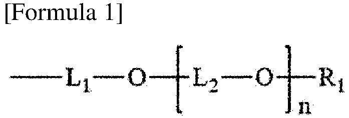

In Formula 1, L₁ is a single bond, an alkylene group or an alkylidene group, L₂ is an alkylene group or an alkylidene group, R₁ is hydrogen or an alkyl group, and n is an arbitrary number.

In Formula 1, the matter that L₁ is a single bond means a form that L₁ does not exist and the oxygen atom between L₁ and L₂ is directly connected to the monomer.

In one example, the alkyl group of R₁ in Formula 1 may be an alkyl group with 1 to 20 carbon atoms, 1 to 16 carbon atoms, 1 to 12 carbon atoms, 1 to 8 carbon atoms or 1 to 4 carbon atoms, or may be a methyl group or an ethyl group. The alkyl group may be linear, branched, or cyclic, and may be linear or branched, as appropriate. The alkyl group may be optionally substituted with one or more substituents.

The term alkylene group means a divalent functional group formed by removing one hydrogen atom from each of two different carbon atoms of an alkane, and the term alkylidene group means a divalent functional group formed by removing two hydrogen atoms from one carbon atom of an alkane.

In one example, the alkylene groups of L₁ and L₂ in Formula 1 may each be an alkylene group with 2 to 20 carbon atoms, 2 to 16 carbon atoms, 2 to 12 carbon atoms, 2 to 8 carbon atoms or 2 to 4 carbon atoms, or may each be an ethylene group or a propylene group. The alkylene group may be linear, branched, or cyclic, and may be linear or branched, as appropriate. The alkylene group may be optionally substituted with one or more substituents.

In one example, the alkylidene groups of L₁ and L₂ in Formula 1 may each be an alkylidene group with 1 to 20 carbon atoms, 1 to 16 carbon atoms, 1 to 12 carbon atoms, 1 to 8 carbon atoms or 1 to 4 carbon atoms, or may each be a methylidene group, an ethylene group or a propylidene group. The alkylidene group may be linear, branched, or cyclic, and may be linear or branched, as appropriate. The alkylidene group may be optionally substituted with one or more substituents.

In Formula 1, the lower limit of n may be 1, 2, 3, or 4, and the upper limit thereof may be 10, 9, 8, 7, 6, 5, 4, or 3 or so. The above m may be within a range of more than or equal to, or more than any lower limit arbitrarily selected from the above-listed lower limits while being less than or equal to, or less than any upper limit arbitrarily selected from the above-listed upper limits.

The polar functional group may bind the polymer layer to another layer to have an appropriate bonding force, and may significantly improve dispersibility of a conductive material, which is described below, in the polymer layer in combination with the long-chain hydrocarbon functional group. In addition, the polar functional group may also play a role in suppressing the PTC effect from appearing at a relatively low temperature.

The mole numbers of the polar functional group and the long-chain hydrocarbon functional group in the conductive polymer may be controlled to ensure an appropriate effect.

For example, the lower limit of the ratio (M_{L}/M_{P}) of the mole number (M_{L}) of the long-chain hydrocarbon functional group or the mole number (M_{L}) of the monomer units having the long-chain hydrocarbon functional group to the mole number (M_{P}) of the polar functional group or the mole number (M_{P}) of the monomer units having the polar functional group in the conductive polymer may be 1, 1.5, 2, 2.5, 3, 3.5, 4, 4.5, 5, 5.5, 6 6.5, 7, 7.5, 8, 8.5, 9, 10, 13, 15, 17, or 19 or so, and the upper limit thereof may be 500, 450, 400, 350, 300, 250, 200, 150, 100, 90, 80, 70, 60, 50, 40, 30, 20, 19, 18, 17, 16, 15, 14, 13, 12, 11, 10, or 9.5 or so. The ratio M_{L}/M_{P} may be within a range of less than or equal to, or less than any upper limit arbitrarily selected from the above-listed upper limits; or within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits. Here, when the ratio M_{L}/M_{P} is a ratio between monomer units, the relevant ratio may be a ratio of the mole number M_{L} of monomer units having all long-chain hydrocarbon functional groups present in the conductive polymer to the mole number M_{P} of monomer units having all polar functional groups; or a ratio of the mole number M_{L} of monomers having all long-chain hydrocarbon functional groups applied to manufacture the conductive polymer to the mole number M_{P} of monomers having all polar functional groups.

The ratio of the sum mole number M_{S} of the monomer units having the long-chain hydrocarbon functional group and the monomer units having the polar functional group to the mole number M of all monomer units in the conductive polymer may be adjusted within the same range as the ratio 100×M_{T}/M as described above. In this instance, the mole number M_{S} is substituted instead of the mole number M_{T}.

For example, the conductive polymer may contain a unit of Formula 2 below as the thiophene monomer unit.

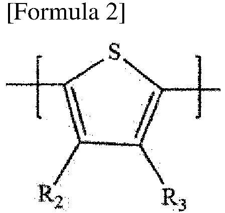

In Formula 2, R₂ and R₃ may each independently be hydrogen, the polar functional group, or the long-chain hydrocarbon functional group. In another example, R₂ and R₃ of Formula 2 may also be connected to each other to form a divalent functional group of Formula 3.

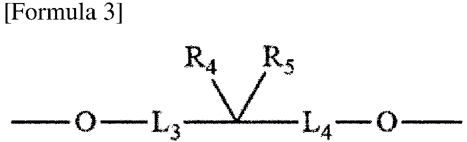

In Formula 3, L₃ and L₄ may each independently be a single bond, an alkylene group, or an alkylidene group, and R₄ and R₅ may each independently be hydrogen, the polar functional group, or the long-chain hydrocarbon functional group.

In Formula 2, when R₂ and R₃ are each independently hydrogen, a polar functional group, or a long-chain hydrocarbon functional group, at least one of R₂ and R₃ above may be the polar functional group or the long-chain hydrocarbon functional group.

In Formula 2, when R₂ and R₃ form the divalent functional group of Formula 3, at least one of R₄ and R₅ above may be the polar functional group or the long-chain hydrocarbon functional group.

In Formula 3, the meanings of the single bond, alkylene group, and alkylidene group, and specific examples are the same as in Formula 1. The technical significance and specific examples of the long-chain hydrocarbon functional group and polar functional group in Formulas 2 and 3 are as described above.

The ratio of the mole number M_{C2} of the unit of Formula 2 to the mole number M of the total monomer units of the conductive polymer may be adjusted to be the same as the ratio 100×M_{T}/M, where M₁ is replaced by M_{C2}.

In one example, the conductive polymer may contain a monomer unit represented by Formula 4 below. The monomer unit of Formula 4 above may be one example of the monomer units having the first hydrocarbon functional group.

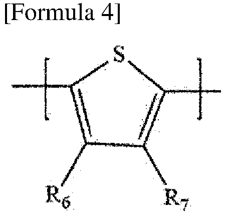

In Formula 4, R₆ and R₇ may each independently be hydrogen or the first hydrocarbon functional group. In this case, one or more of R₆ and R₇ above may be the first hydrocarbon functional group.

In another example, R₆ and R₇ above may be connected to each other to form a divalent functional group of Formula 5.

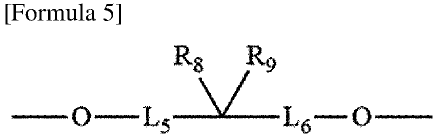

In Formula 5, L₅ and L₆ are each independently a single bond, an alkylene group, or an alkylidene group, and R₈ and R₉ are each independently hydrogen or the first hydrocarbon functional group, but at least one of R₈ and R₉ may be the first hydrocarbon functional group.

The specific details of the first hydrocarbon functional group are as described above, and the specific details of the single bond, alkylene group, or alkylidene group are as described in Formula 1 above.

The conductive polymer may also contain a monomer unit represented by Formula 6 below. The monomer unit of Formula 6 above may be one example of the monomer units having the second hydrocarbon functional group.

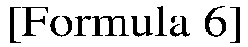

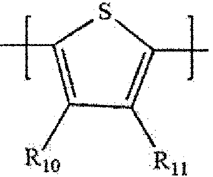

In Formula 6, R₁₀ and R₁₁ may each independently be hydrogen or the second hydrocarbon functional group, and in this case, one or more of R₁₀ and R₁₁ above may be the second hydrocarbon functional group.

In another example, R₁₀ and R₁₁ above may be connected to each other to form a divalent functional group of Formula 7 below.

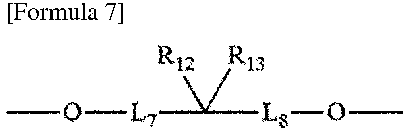

In Formula 7, L₇ and L₈ are each independently a single bond, an alkylene group, or an alkylidene group, and R₁₂ and R₁₃ are each independently hydrogen or the second hydrocarbon functional group, but at least one of R₁₂ and R₁₃ is the second hydrocarbon functional group.

The specific details of the second hydrocarbon functional group are as described above, and the specific details of the single bond, the alkylene group, and the alkylidene group are as described in Formula 1.

The conductive polymer may also contain a monomer unit represented by Formula 8 below. The monomer unit of Formula 8 above may be one example of the monomer units having the polar functional group.

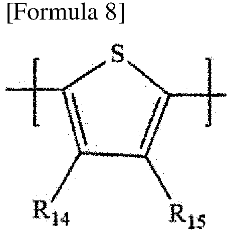

In Formula 8, R₁₄ and R₁₅ may each independently be hydrogen or the polar functional group. In the above case, one or more of R₁₄ and R₁₅ above are the polar functional group.

In another example, R₁₄ and R₁₅ of Formula 8 above may be connected to each other to form a divalent functional group of Formula 9 below.

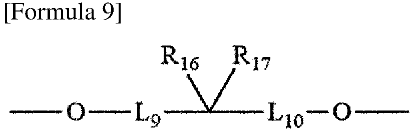

In Formula 9, L₉ and L₁₀ are each independently a single bond, an alkylene group, or an alkylidene group, and R₁₆ and R₁₇ are each independently hydrogen or a polar functional group, but at least one of R₁₆ and R₁₇ is the polar functional group.

The specific details of the polar functional group are as described above, and the specific details of the single bond, alkylene group, and alkylidene group are as described in Formula 1.

In the case where the conductive polymer simultaneously contains the monomer unit of Formula 4 above and the monomer unit of Formula 6 above, the ratio of the sum mole number M₄₊₆ of the monomer unit of Formula 4 above and the monomer unit of Formula 6 above to the mole number M of the total monomer units included in the conductive polymer may be adjusted within the same range as the ratio 100×M₁/M as described above, where M_{L} is replaced by M₄₊₆.

The ratio of the mole number M₄ of the monomer unit of Formula 4 above and the mole number M₆ of the monomer unit of Formula 6 above may be adjusted within the same range as the ratio M₂/M₁. At this time, the mole number M₁ may be the mole number of the monomer unit of Formula 4 above, and the mole number M₂ may be the mole number of the monomer unit of Formula 6 above.

When the conductive polymer contains the monomer unit of Formula 8 above, the unit may be included so that the molar ratio M_{L}/M_{P} is satisfied. In this instance, the mole number of the monomer unit of Formula 8 above becomes the mole number M_{P}. In addition, the mole number M_{L} may be the mole number of the monomer unit of Formula 4 above, the mole number of the monomer unit of Formula 6 above, or the sum mole number of the monomer unit of Formula 4 above and the monomer unit of Formula 6 above.

When the monomer units of Formulas 4, 6, and 8 above are present in the conductive polymer, the ratio of the sum mole number M₄₊₆₊₈ of the monomer units of Formulas 4, 6, and 8 above to the sum mole number M of all monomer units in the conductive polymer may be adjusted within the same range as the ratio 100×M_{T}/M. In this instance, the mole number M₄₊₆₊₈ becomes the mole number M_{T}.

The conductive polymer may comprise the monomer units, and may further comprise other monomer units.

The conductive polymer may have a weight average molecular weight in a predetermined range. The lower limit of the weight average molecular weight of the conductive polymer may be 10,000, 15,000, 20,000, 25,000, 30,000, 35,000, 40,000, 45,000, 50,000, 55,000, 60,000, 65,000, 70,000, 75,000, 80,000, 85,000, 90,000, 95,000, 100,000, 110,000, 120,000, 130,000, or 135,000 or so, and the upper limit thereof may also be 1,000,000, 950,000, 900,000, 850,000, 800,000, 750,000, 700,000, 650,000, 600,000, 550,000, 500,000, 450,000, 400,000, 350,000, 300,000, 250,000, 200,000, 150,000, 130,000, 110,000, or 100,000 or so. The weight average molecular weight may be within a range of less than or equal to, or less than any upper limit arbitrarily selected from the above-listed upper limits while being more than or equal to, or more than any lower limit arbitrarily selected from the above-listed lower limits. The unit of the weight average molecular weight is g/mol, which may be confirmed according to the description of "2. GPC (Gel Permeation Chromatograph) analysis" of Example sections of this specification.

The molecular weight distribution of the conductive polymer, i.e., the ratio (Mw/Mn) of the weight average molecular weight (Mw) to the number average molecular weight (Mn) may be within a predetermined range. The lower limit of the molecular weight distribution may be 2, 2.5, 3, 3.5, 4, 4.5, or 5 or so, and the upper limit thereof may be 8, 7.5, 7, 6.5, 6, 5.5, 5, 4.5, 4, or 3.7 or so. The molecular weight distribution may have a range of less than or equal to, or less than any upper limit arbitrarily selected from the above-listed upper limits while being more than or equal to, or more than any lower limit arbitrarily selected from the above-listed lower limits. The molecular weight distribution may be confirmed according to the description of "2. GPC (Gel Permeation Chromatograph) analysis" of Example sections of this specification.

The polymer layer comprises the conductive polymer, and accordingly, may exhibit the above-described characteristics. The polymer layer may also comprise any additional component if it comprises the conductive polymer.

For example, the polymer layer may further comprise a conductive material together with the conductive polymer. Through addition of such a material, the characteristics of the polymer layer may be further adjusted depending on the purpose. As the conductive material, a material having appropriate conductivity may be used, and for example, as the conductive material one, or two or more selected from carbon particles, carbon fibers, graphene, graphite, carbon black, and carbon nanotubes, and the like may be used.

As the conductive material, an appropriate type may be selected and used from the types as described above, and the shape of the material may be a particle shape (spherical, irregular, or other shape), a plate shape, or a fiber shape, and the like, but is not limited thereto.

The size of the conductive material may also be appropriately adjusted as needed. For example, the lower limit of the size of the conductive material may be 10 nm, 50 nm, 100 nm, 150 nm, 200 nm, 250 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1000 nm, 5000 nm, or 10000 nm or so, and the upper limit thereof may also be 100000 nm, 90000 nm, 80000 nm, 70000 nm, 60000 nm, 50000 nm, 40000 nm, 30000 nm, 20000 nm, 10000 nm, 5000 nm, 1000 nm, 950 nm, 900 nm, 850 nm, 800 nm, 750 nm, 700 nm, 650 nm, 600 nm, 550 nm, 500 nm, 450 nm, 400 nm, 350 nm, 300 nm, 250 nm, 200 nm, 200 nm, 150 nm, 100 nm, 90 nm, 80 nm, or 70 nm or so. The size may be within a range of less than or equal to, or less than any upper limit arbitrarily selected from the above-listed upper limits; or within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

The size is the average diameter (so-called D50 particle diameter) measured according to "4. Average particle diameter measurement" section described in Example sections of this specification.

If necessary, the conductive material may also be surface-treated, considering dispersibility and coating properties. Particularly, through such surface treatment, it is possible to secure coating properties stably, and it is possible to form a uniform polymer layer.

In this case, a surface-treating agent having appropriate compatibility with the conductive polymer may be used as the surface-treating agent. For example, the conductive material may be surface-treated with a polyphenol-based compound as the surface-treating agent. The polyphenol-based compound means a compound including a structure containing two or more hydroxyl groups which are substituted in benzene, and connected thereto. Such a compound may be exemplified by a so-called catechol compound (i.e., catechol, or compound including the relevant structure), and an example thereof includes dopamine, polydopamine, 3,4-dihydroxy phenyl alanine, norepinephrine, tannic acid, humic acid, and/or lignin, and the like, but is not limited thereto.

The method of surface-treating the conductive material with the surface-treating agent is not limited, and for example, a method of mixing the conductive material and the surface-treating agent in an appropriate solvent, and the like, or a method of synthesizing or polymerizing the surface-treating agent on the surface of the conductive material may be applied.

The content of the conductive material may be adjusted in consideration of the desired oxidation potential. In general, as the content of the conductive material in the polymer layer increases, the oxidation potential of the polymer layer decreases. Therefore, the content of the conductive material may be adjusted in consideration of the oxidation potential of the electrode active material and accordingly, the required oxidation potential of the polymer layer. For example, the lower limit of the content of the conductive material in the polymer layer, relative to 100 parts by weight of the conductive polymer, may be 0.5 parts by weight, 1 part by weight, 5 parts by weight, 10 parts by weight, 15 parts by weight, 20 parts by weight, 30 parts by weight, 40 parts by weight, 50 parts by weight, 60 parts by weight, 70 parts by weight, 80 parts by weight, 90 parts by weight, or 100 parts by weight or so, and the upper limit thereof may be 1,000 parts by weight, 900 parts by weight, 800 parts by weight, 700 parts by weight, 600 parts by weight, 500 parts by weight, 400 parts by weight, 300 parts by weight, 200 parts by weight, 150 parts by weight, 100 parts by weight, 50 parts by weight, 48 parts by weight, 46 parts by weight, 44 parts by weight, 42 parts by weight, 40 parts by weight, 38 parts by weight, 36 parts by weight, 34 parts by weight, 32 parts by weight, 30 parts by weight, 28 parts by weight, 26 parts by weight, 24 parts by weight, 22 parts by weight, 20 parts by weight, 18 parts by weight, 16 parts by weight, 14 parts by weight, 12 parts by weight, or 10 parts by weight or so. The content may be within a range of less than or equal to, or less than any upper limit arbitrarily selected from the above-listed upper limits; or within a range of more than or equal to, or more than any lower limit arbitrarily selected from the above-listed lower limits; or within a range of more than or equal to, or more than any lower limit arbitrarily selected from the above-listed lower limits while being less than or equal to, or less than any upper limit arbitrarily selected from the above-listed upper limits.

Under such a ratio, the conductive material appropriately interacts with the conductive polymer, whereby it is possible that a polymer layer in a desired shape may be effectively formed.

The present specification also discloses a method for manufacturing the polymer layer.

As described above, in order that the polymer layer exhibits the desired effect, selection of the long-chain hydrocarbon functional group and/or the conductive material is important, and additionally, control of the arrangement state of the long-chain hydrocarbon functional group and/or the dispersion state of the conductive material is important, where the desired arrangement and/or dispersion state may be secured by a manufacturing method to be described below. Furthermore, the desired intermolecular distance can also be effectively secured by a manufacturing method to be described below.

The manufacturing method may comprise, for example, steps of forming a polymer layer precursor comprising the conductive polymer and heat-treating the polymer layer precursor.

The conductive polymer and the like may be prepared using known methods. For example, as methods for preparing polythiophene, a method of utilizing oxidative polymerization or a method of utilizing radical reactions, and the like are known, and these methods may be applied even in the process of forming the conductive polymer. Furthermore, as the conductive material, commercially available products may also be used, and its surface treatment may also be performed using a known method.

The polymer layer precursor is, for example, a layer comprising the conductive polymer and, if necessary, comprising additional components such as a conductive material, which means a layer that is converted to the polymer layer. Such a precursor may be formed using a known method, and may be formed, for example, by a method of coating a polymer solution in which the conductive polymer or the like is dispersed in an appropriate solvent.

When the polymer solution is coated onto the current collector body and the process is performed, the manufacturing method becomes the method for manufacturing the current collector as described above.

As the solvent, an appropriate solvent capable of dispersing the conductive polymer and the conductive material may be selected, and for example, an ether-based solvent such as diethyl ether, tetrahydrofuran, dioxane, trioxane, dimethoxy ethane, or toluene; an aromatic hydrocarbon-based solvent such as ethyl benzene, or an alicyclic hydrocarbon solvent such as cyclohexane; or a tertiary amine-based solvent such as tetramethylethylenediamine (TMEDA) or hexamethylphosphorictriamide (HMPA), or the like may be used, or a mixed solvent including two or more of the foregoing, and the like may be used, but is not limited thereto.

The polymer solution is used to form a polymer layer precursor. This process may usually be performed through a process of coating the polymer solution on an appropriate process base material. In this instance, the coating method is not particularly limited.

The manufacturing method further comprises a step of heat-treating the precursor of the polymer layer. By adjusting the conditions during this process, the orientation state of the conductive polymer (e.g., the orientation state of the long-chain hydrocarbon functional group and/or polar functional group) and/or the dispersion state of the conductive material is adjusted, whereby it is possible to form a polymer layer exhibiting the desired effect.

The heat treatment step may be performed in two steps. For example, the heat treatment step may comprise a first step of performing primary heat treatment on the polymer layer precursor; and a second step of performing secondary heat treatment on the polymer layer precursor in which the first step has been conducted.

The conditions of the first and second steps may be adjusted for achievement of the desired orientation or alignment of the functional groups and the dispersion state of the conductive material.

For example, the temperature T1 of the primary heat treatment and the temperature T2 of the secondary heat treatment may be adjusted. For example, the lower limit of the ratio (T1/T2) of the temperatures T1 and T2 may be 0.1, 0.2, 0.3, 0.4, 0.5, 0.6, 0.7, 0.8, 0.9, 1, 1.1, or 1.2 or so, and the upper limit thereof may be 10, 5, 4.5, 4, 3.5, 3, 2.5, 2, 1.9, 1.8, 1.7, 1.6, 1.5, 1.4, 1.3, or 1.2 or so. The ratio may be within a range of more than or equal to, or more than any lower limit arbitrarily selected from the above-listed lower limits; or within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits.

For example, the temperature T1 of the primary heat treatment may be adjusted within a predetermined range. For example, the lower limit of the temperature T1 may be about 50°C, 55°C, 60°C, 65°C, 70°C, 75°C, 80°C, 85°C, 90°C, 95°C, 100°C, 105°C, 110°C, 115°C, 120°C, 125°C, 130°C, 135°C or 140°C, and the upper limit thereof may be 300°C, 290°C, 280°C, 270°C, 260°C, 250°C, 240°C, 230°C, 220°C, 210°C, 200°C, 190°C, 180°C, 170°C, 160°C, 150°C or 140°C. The temperature T1 may be within a range of more than or equal to, or more than any lower limit arbitrarily selected from the above-listed lower limits; or within a range of less than or equal to, or less than any upper limit arbitrarily selected from the above-listed upper limits while being more than or equal to, or more than any lower limit arbitrarily selected from the above-listed lower limits.

To form the desired polymer layer, the primary heat treatment temperature may be achieved by increasing the temperature at a specific heating rate.

The ratio of the heat treatment time S1 in the primary heat treatment and the heat treatment time S2 in the secondary heat treatment may be further adjusted. For example, the lower limit of the ratio S2/S1 may be 1, 2, 3, 4, 5, 6, 7, 8, 9, 10, 11, 12, 13, 14, 15, 20, 50, 70, 100, 110, 120, 130, 140, 150, 160, 170, 180, 190, 200, 210, 220, 230, 240, 250, 260, or 270 or so, and the upper limit thereof may be 1,000, 950, 900, 850, 800, 750, 700, 650, 600, 550, 500, 450, 400, 350, 300, 290, 280, 270, 250, 200, 150, 100, 90, 80, 70, 60, 50, 40, 30, or 20 or so. The ratio S2/S1 may be within a range of more than or equal to, or more than any lower limit arbitrarily selected from the above-listed lower limits; or within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits.

The lower limit of the secondary heat treatment time S2 may be 0.1 hours, 0.2 hours, 0.3 hours, 0.4 hours, 0.5 hours, 0.6 hours, 0.7 hours, 0.8 hours, 0.9 hours, 1 hour, 2 hours, 3 hours, 4 hours, 5 hours, 6 hours, 7 hours, 8 hours, 9 hours, 10 hours, 11 hours, 12 hours, 13 hours, 14 hours, 15 hours, 16 hours, 17 hours, or 18 hours or so, and the upper limit thereof may be 50 hours, 48 hours, 46 hours, 44 hours, 42 hours, 40 hours, 38 hours, 36 hours, 34 hours, 32 hours, 30 hours, 28 hours, 26 hours, 24 hours, 22 hours, 20 hours, 18 hours, 16 hours, 14 hours, 12 hours, or 10 hours or so. The secondary heat treatment time S2 may be within a range of more than or equal to, or more than any lower limit arbitrarily selected from the above-listed lower limits; or within a range of less than or equal to, or less than any upper limit arbitrarily selected from the above-listed upper limits; or within a range of less than or equal to, or less than any upper limit arbitrarily selected from the above-listed upper limits while being more than or equal to, or more than any lower limit arbitrarily selected from the above-listed lower limits.

The polymer layer may be formed through the above processes.

The present specification also discloses an electrode comprising the current collector.

As described above, the electrode may sequentially comprise the current collector body; the polymer layer; and the active material layer.

The polymer layer may be, specifically, a polymer layer included in the above-described current collector to be formed on the current collector body.

A commonly applied layer may also be used as the active material layer.

Typically, the active material layer comprises an electrode active material. The specific type of the electrode active material is not particularly limited, and materials to form a positive electrode or a negative electrode may usually be used.

For example, when the active material layer is a positive electrode active material layer, the electrode active material may include layered compounds such as lithium nickel oxide (LiNiO₂), or compounds substituted with one or more transition metals; lithium iron oxides such as LiFe₃O₄; lithium manganese oxides such as Formula Li_{1+c1}Mn_{2-c1}O₄ (0≤c1≤0.33), LiMnO₃, LiMn₂O₃, or LiMnO₂; lithium copper oxides (Li₂CuO₂); vanadium oxides such as LiV₃O₈, V₂O₅, or Cu₂V₂O₇; Ni-site lithium nickel oxides represented by Formula LiNi_{1-c2}M_{c2}O₂ (where M is at least one selected from the group consisting of Co, Mn, Al, Cu, Fe, Mg, B and Ga, and 0.01≤c2≤0.3 is satisfied); lithium manganese composite oxides represented by Formula LiMn_{2-c3}M_{c3}O₂ (where M is at least one selected from the group consisting of Co, Ni, Fe, Cr, Zn, and Ta, and 0.01≤c3≤0.1 is satisfied) or Li₂Mn₃MO₈ (here, M is at least one selected from the group consisting of Fe, Co, Ni, Cu and Zn); lithium nickel cobalt manganese (NCM) composite oxides, lithium nickel cobalt manganese aluminum (NCMA) composite oxides, and LiMn₂O₄ in which a part of Li in the formula is substituted with alkaline earth metal ions, and the like, but is not limited thereto.

When the active material layer is a negative electrode active material layer, as the electrode active material, for example, a compound capable of reversible intercalation and deintercalation of lithium may be used. A specific example may include carbonaceous materials such as artificial graphite, natural graphite, graphitized carbon fiber, and amorphous carbon; metallic compounds capable of alloying with lithium, such as Si, Al, Sn, Pb, Zn, Bi, In, Mg, Ga, Cd, Si alloy, Sn alloy, or Al alloy; metal oxides capable of doping and de-doping lithium, such as SiOₐ (0 < a < 2), SnO₂, vanadium oxide, and lithium vanadium oxide; or a composite comprising the metallic compound and the carbonaceous materials such as a Si-C composite or a Sn-C composite, and the like, and any one or a mixture of two or more of the foregoing may be used.

A metal lithium thin film may also be used as the negative electrode active material, and as the carbon material, low crystalline carbon and high crystalline carbon, and the like may also be used. As the low crystalline carbon, soft carbon and hard carbon are representative, and as the high crystalline carbon, high-temperature baked carbons such as amorphous, plate-like, scale-like, spherical, or fibrous natural graphite or artificial graphite, Kish graphite, pyrolytic carbon, mesophase pitch based carbon fiber, mesocarbon microbeads, mesophase pitches, and petroleum and coal tar pitch derived cokes are representative.

The electrode active material may be included in the active material layer within a range of about 80 weight% to 99.5 weight%, or within a range of 88 weight% to 99 weight%, relative to the total weight of the active material layer, but the ratio may be changed depending on the use or design of the electrode.

The active material layer may further comprise a binder. The binder serves to improve attachment between the active materials, and adhesive force on between the active material layer and the current collector body. An example of the binder is not particularly limited, and one or more may be selected from the group consisting of, for example, PVDF (poly(vinylidene fluoride), PVA (poly(vinyl alcohol)), SBR (styrene butadiene rubber), PEO (poly(ethylene oxide)), CMC (carboxyl methyl cellulose), cellulose acetate, cellulose acetate butylate, cellulose acetate propionate, cyanoethylpullulan, cyanoethyl polyvinyl alcohol, cyanoethyl cellulose, cyanoethyl sucrose, pullulan, polymethylmethacrylate, polybutylacrylate, polyacrylonitrile, polyvinylpyrrolidone, polyvinylacetate, an ethylene vinyl acetate copolymer (polyethylene-co-vinyl acetate), and polyarylate, and used.

In one example, the binder may be included in the active material layer within a range of 0.1 parts by weight to 10 parts by weight or 0.5 parts by weight to 5 parts by weight, relative to 100 parts by weight of the electrode active material, but is not limited thereto.

The active material layer may further comprise a conductive material, as needed. If the conductive material has conductivity without causing chemical changes in the secondary battery, it is not particularly limited, any known material can be used. For example, graphite such as natural graphite or artificial graphite; carbon black, such as carbon black, acetylene black, Ketjen black, channel black, furnace black, lamp black, or thermal black; conductive fibers such as carbon fibers or metal fibers; conductive tubes such as carbon nanotubes (CNTs); metal powders such as fluorocarbon, aluminum, or nickel powder; conductive whiskers such as zinc oxide or potassium titanate; conductive metal oxides such as titanium oxide; conductive materials such as polyphenylene derivatives, and the like may be used.

In one example, the conductive material may be included in the active material layer in an amount of 0.1 parts by weight to 20 parts by weight or 0.3 parts by weight to 10 parts by weight, relative to 100 parts by weight of the electrode active material, but is not limited thereto.

The active material layer may also further comprise any necessary known components in addition to the above-described components optionally.

The present specification discloses a method for manufacturing the electrode.

Such a manufacturing method may comprise a step of forming the active material layer on the polymer layer on the current collector body.

The method of forming the active material layer on the polymer layer is not particularly limited as well. Typically, the active material layer is formed by coating a slurry containing the electrode active material, a binder, and a conductive material, and the like on the current collector body (on the polymer layer), drying, and then rolling, and such a known method may be applied in the same manner. Therefore, the manufacturing method may comprise a step of rolling the active material layer of the above-described electrode (i.e., electrode without protrusions in the sliding region of the active material layer).

The present specification also discloses an electrode assembly or an electrochemical element, for example, a secondary battery, which comprises such an electrode.

The electrochemical element may comprise the electrode as a positive electrode and/or a negative electrode. If the electrode is used as a negative electrode and/or a positive electrode, other constitutions or manufacturing methods of the electrochemical element are not particularly limited, and known methods may be applied.

### Advantageous Effects

The present specification discloses a current collector and a use thereof. The current collector comprises a polymer layer exhibiting a so-called PTC (Positive Temperature Coefficient) effect at a required level at a required time, whereby it can be suitably applied in applications where stability problems due to abnormally high heat and/or flame are caused. In the polymer layer of the current collector, the PTC effect can rapidly appear at a required time. The present specification also discloses a use of the current collector.

### Description of Drawings

Figure 1 is a cross-sectional diagram of an exemplary current collector.
Figure 2 is a cross-sectional diagram of an exemplary electrode.
Figure 3 is an NMR analysis result for a monomer of Preparation Example 1.
Figure 4 is an NMR analysis result for a conductive polymer of Preparation Example 2.
Figure 5 is results of performing an XRD (X-ray diffraction) analysis on a polymer layer.
Figure 6 is results of performing an XRD (X-ray diffraction) analysis on a polymer layer.
Figure 7 is photographs of a case where conductive polymers are dispersed in toluene at a concentration of 3 weight%.
Figure 8 is a view showing EIS impedance plot results of polymer layers depending on temperatures.
Figure 9 is a view showing EIS impedance changes relative to potentials in a range of 3 V to 4.5 V.
Figure 10 is a view showing EIS impedance changes relative to potentials in a range of 3 V to 4.5 V.
Figure 11 is EIS Nyquist plots at other applied voltages.
Figure 12 is CV (Cyclic voltammetry) curves confirmed for Examples at a scan rate (sweep rate) of 0.4 mV/s.
Figure 13 is CV (Cyclic voltammetry) curves of Example 1 at scan rates (sweep rates) in a range of 0.15 mV/s to 0.8 mV/s.
Figure 14 is CV (Cyclic voltammetry) curves of Example 2 at scan rates in a range of 0.15 mV/s to 0.8 mV/s.
Figure 15 is CV curves of Examples 1 and 3 according to cycles.
Figure 16 is a view showing results of a galvanostatic cycling test for Examples.
Figure 17 is charge-and-discharge profiles in a cycle test.
Figure 18 is energy density retention results in a cycle test (140 cycles).
Figure 19 is rate test results for a 3-Ah pouch cell.
Figure 20 is cycle test results for a 3-Ah pouch cell.
Figure 21 is views showing results of an ARC test for a test example.
Figure 22 is XRF observation results for electrodes of Examples and Comparative Examples.
Figure 23 is a diagram showing a process of performing a needle test.
Figure 24 is views showing results of a needle test.
Figure 25 is a diagram showing a method for performing an impact test and the results thereof.

### Mode for Invention

Hereinafter, the current collector, and the like are specifically described through examples and comparative examples, but the scope of the current collector and the like are not limited to the following examples.

### 1. NMR analysis

¹H-NMR analyses were performed at room temperature (25°C) using an NMR spectrometer (including a Bruker UltraShield spectrometer (300 MHz)) with a 5 mm triple resonance probe. A sample was diluted in a solvent (CDCl₃) for NMR measurement to a concentration of 10 mg/ml or so and used, and the chemical shift was expressed in ppm.

### 2. GPC (Gel Permeation Chromatograph) analysis

Molecular weight characteristics were measured using GPC (Gel permeation chromatography). A sample is placed in a 5 mL vial and diluted with chloroform to a concentration of about 1 mg/mL or so. The standard sample for calibration and the sample to be analyzed were filtered through a syringe filter (pore size: 0.45 µm), and then the molecular weight characteristics were measured. As the analysis program, Waters' Empower 3 was used, and a weight average molecular weight (Mw) and a number average molecular weight (Mn) were each obtained by comparing the elution time of the sample with the calibration curve, and the molecular weight distribution (PDI) was calculated by the ratio (Mw/Mn).

The measurement conditions of GPC are as follows.

### <GPC measurement conditions>

Device: Waters' 2414
Column: using 3 Styragels from Waters
Solvent: THF (tetrahydrofuran)
Column temperature: 35°C
Sample concentration: 1mg/mL, 1µL injection
Standard sample: polystyrene (Mp: 3900000, 723000, 316500, 52200, 31400, 7200, 3940, 485)

### 3. Thickness measurement

A cross-section of a thickness measurement target was exposed using an ion milling device (Hitachi, IM5000), and then, a Scanning Electron Microscope (SEM) (JEOL, JSM-7200F) image of the cross-section was captured, and a thickness was obtained from the image. The cross-section exposure was performed using the ion milling equipment (Hitachi, IM5000) in a cross-section milling mode under conditions of a speed (reciprocation/min) of 3, an acceleration voltage of 6 kD, a discharge voltage of 15 kV, and a current of 150 µA, with setting a time of 4 hours. The SEM (Scanning Electron Microscope) (JEOL, JSM-7200F) image was magnified within a range of 500 times to 20,000 times, and captured under a voltage condition of 5kV.

### 4.. Average particle diameter measurement

An average particle diameter (D50 particle diameter) was measured using Marvern's MASTERSIZER3000 device in accordance with ISO-13320 standard. Toluene was used as a solvent upon measurement. If the sample (particles) is dispersed in the solvent and irradiated with lasers, the lasers are scattered by the sample dispersed in the solvent. Since strengths and directionality of the scattered lasers vary depending on the particle size, the average particle diameter can be obtained by analyzing them using Mie theory. Through the analysis, the measurement results were converted to the particle diameters of spheres with the same volume as the dispersed sample, thereby resulting in a volume-based cumulative graph of the particle size distribution, and the particle diameter (median particle diameter) at 50% cumulative point in the graph was designated as the average particle diameter (D50 particle diameter).

### 5. EIS measurement

Through EIS (Electrochemical Impedance Spectroscopy, Electrochemical Impedance Analysis), it was evaluated using a coin cell. A separator and a lithium film (thickness: about 300µm) were laminated on a current collector (Example: Al foil/polymer layer, Comparative Example: Al foil) of an example or a comparative example, to manufacture a laminate (Example: Al foil/polymer layer/separator/lithium film, Comparative Example: Al foil/separator/lithium film), and the laminate was punched into a circle with a diameter of about 1.4 cm. The coin cell was manufactured using Wellcos' CR2032 coin cell kit, the punched laminate, and an electrolyte. As the separator, a separator of the WL20C model from W-SCOPE KOREA was used, and as the electrolyte, GTHR KOREA's electrolyte (1 M LiPF₆ solution, solvent = EC: DMC: DEC (3:3:4, volume ratio) (EC: Ethylene Carbonate, DMC: dimethyl carbonate, EMC: ethylmethyl carbonate)) (3 µL mAh⁻¹) was used.

A voltage of 4.3V was applied to the coin cell at room temperature (25°C) for 10 minutes, and the impedance obtained in the high-frequency region of the Nyquist plot obtained by the EIS measuring method at 50,000 Hz to 0.1 Hz was measured. A potentiostat (Princeton Applied Research, PARASTAT-MC) was used as the EIS measurement device.

Upon measuring impedance according to temperature changes, the coin cell was placed at the center in a convection oven (Jeotech, OF3-05W), and the impedance was measured while the oven temperature was increased from 25°C to 130°C at a rate of 2°C/min.

### Preparation Example 1. Synthesis of monomer (A)

The monomer of the following Formula A was synthesized in the following manner.

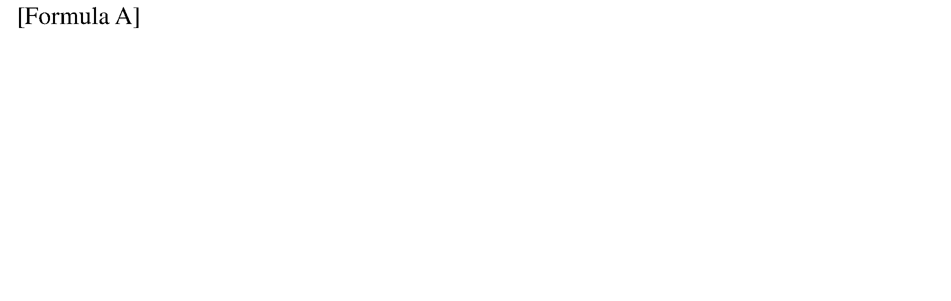

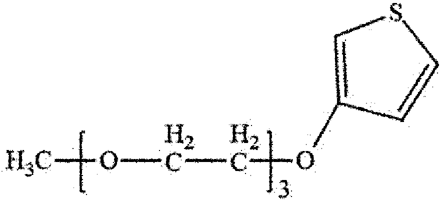

3 g (26.28 mmol, 1 eq) of 3-methoxythiophene and 7.03 g (39.42 mmol, 1.5 eq) of triethylene glycol monomethyl ether were dissolved together with 500 mg of p-toluenesulfonic acid (p-TsOH) (2.63 mmol, 0.1 eq) in 150 ml of toluene, and mixed. The mixture was refluxed at 120°C under a nitrogen atmosphere and simultaneously reacted, whereby methanol produced by the reaction (transetherification) was removed by 4A type molecular sieves filled in an extractor (soxhlet extractor). The reactant was cooled to room temperature after reflux for 24 hours, and then quenched with water, and extracted with ethyl acetate, and then washed with brine, and dried over magnesium sulfate (MgSO₄). The solvent was removed using a rotary evaporator, and the residue was purified by column chromatography eluting with methylene chloride/hexane (2:1) to obtain the target compound (monomer (A)). The NMR analysis results for the monomer (A) are as shown in Figure 3.

### Preparation Example 2. Synthesis of polythiophene (A)

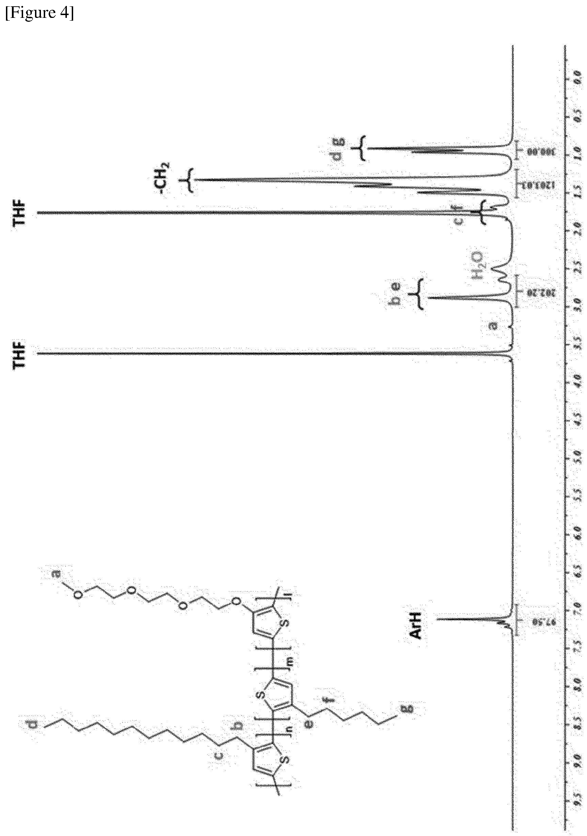

A solution prepared by dispersing 215 g of iron (III) chloride in 700 mL of hexane was stirred vigorously at 30°C for 30 minutes or so. A mixture was prepared by introducing a solution obtained by mixing 53.3 g (about 0.21 mol) of 3-dodecylthiophene, 41.5 g (about 0.25 mol) of 3-hexylthiophene, and 6.1 g (0.024 mol) of the monomer (A) of Preparation Example 1 to hexane, in which the iron chloride was dissolved, at a rate of about 5 mL/min. The mixture was stirred at about 150 rpm for about 1 hour. The temperature was set to about 10°C, and 2.4L of methanol was introduced thereto to obtain a precipitate. The obtained precipitate was redissolved in 2L of THF (Tetrahydrofuran) at 60°C for 5 hours. After redissolution, 2.5 L of methanol was further added to obtain a precipitate through a reprecipitation process, and the precipitate was washed three times with 1.5 L of methanol to remove impurities. After removing impurities, the precipitate was dried at 60°C for 12 hours to produce polythiophene (A). The polythiophene (A) had a weight-average molecular weight (Mw) and a numberaverage molecular weight (Mn) of 138,000 g/mol and 26,000 g/mol or so, respectively. The NMR analysis result for the polythiophene (A) are shown in Figure 4.

### Example 1.

The polythiophene (A) of Preparation Example 2 was dispersed in toluene at a concentration of about 3 weight% to prepare a polymer solution. Subsequently, the polymer solution was fully filled into a pan of a coating device, to perform micro-gravure coating. As a current collector body, an Al foil (SAMA) with a thickness of about 15 µm or so was used. The polymer solution was coated onto the current collector body using the coating device (coating speed: 15 meters per minute). Subsequently, the coated polymer solution was dried at 140°C for 4 minutes or so. Subsequently, the current collector body coated with the polymer solution was further maintained at 110°C for 10 hours to form a polymer layer (thickness: 600 nm), thereby manufacturing a current collector.

Subsequently, an active material layer was formed on the polymer layer, thereby manufacturing an electrode. A slurry comprising lithium cobalt oxide (LiCoO₂) (XTC), a carbon-based conductive agent (ECP (Ketjen Black) 0.5%, SFG (Trimrex graphite) 0.4%, DB (Denka Black) 0.4%), PVDF (polyvinylidene fluoride) (Kureha), and NMP (N-methyl-2-pyrrolidone) in a weight ratio of 75:1:1:23 (LiCoO₂: conductive agent: PVDF: NMP)) was applied to a thickness of about 90 µm or so onto the polymer layer using a doctor blade, and dried at room temperature (about 25°C), and then further dried under vacuum conditions at 120°C to form an active material layer. Subsequently, it was rolled to a porosity of about 25% or so to manufacture an electrode.

### Example 2.

Polythiophene (A) of Preparation Example 2 was dispersed in toluene at a concentration of about 3 weight%. Subsequently, conductive particles (Super C, Imerys) were mixed in the toluene such that the polythiophene (A) and conductive particles (B) were in a weight ratio of 8:2 or so, thereby preparing a polymer solution. Using the polymer solution, a polymer layer was formed on a current collector body in the same manner as in Example 1, thereby manufacturing a current collector and an electrode.

### Example 3.

Polythiophene (A) of Preparation Example 2 was dispersed in toluene at a concentration of about 3 weight%. Subsequently, conductive particles (Super C, Imerys) were mixed in the toluene such that the polythiophene (A) and conductive particles (B) were in a weight ratio of 6:4 or so, thereby preparing a polymer solution. Using the polymer solution, a polymer layer was formed on a current collector body in the same manner as in Example 1, thereby manufacturing a current collector and an electrode.

### Comparative Example 1.

An electrode was manufactured by forming an active material layer directly on an Al foil in the same manner as described in Example 1, without forming any polymer layer.

### Test Example 1.

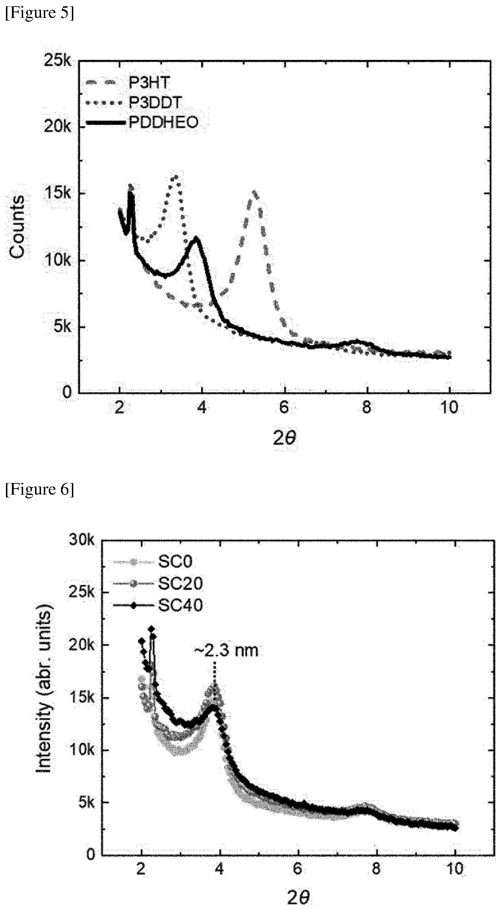

Figures 5 and 6 are results of performing an XRD (X-ray diffraction) analysis on a polymer layer. The XRD analysis was performed using an XRD device (Bruker D8 Discover instrument featuring a Cu-K alpha source operating at 40 kV and 40 mA).

In Figure 5, P3HT is the result for the polymer layer formed using polythiophene synthesized in the same manner as in Preparation Example 2, by applying only 3-hexylthiophene as a monomer; P3DDT is the result for the polymer layer formed using polythiophene synthesized in the same manner as in Preparation Example 2, by applying only 3-dodecylthiophene as a monomer; and PDDHEO is the result for the polymer layer of Example 1. As the method of forming the polymer layers P3HT and P3DDT, the same method as in Example 1 was applied.

In Figure 6, SC0 is the result for the polymer layer of Example 1; SC20 is the result for the polymer layer of Example 2; and SC40 is the result for the polymer layer of Example 3.

From the results of Figure 5, the 2θ peak position of P3HT was about 5.23 degrees, the 2θ peak position of P3DDT was about 3.31 degrees, and the 2θ peak position of PDDHEO was about 3.85 degrees. According to such results, it can be known that the d-spacing of the (100) plane of P3HT is about 1.7 nm or so, the d-spacing of the (100) plane of P3DDT is about 2.7 nm or so, and the d-spacing of the (100) plane of PDDHEO is about 2.3 nm or so.

From such results, it can be known that the intermolecular distance can be controlled depending on selection of the long-chain hydrocarbon functional group introduced into the polythiophene. Furthermore, from the results of Figure 6, it can also be confirmed that once the polythiophene is determined, the addition of conductive particles does not significantly change the intermolecular distance.

### Test Example 2.

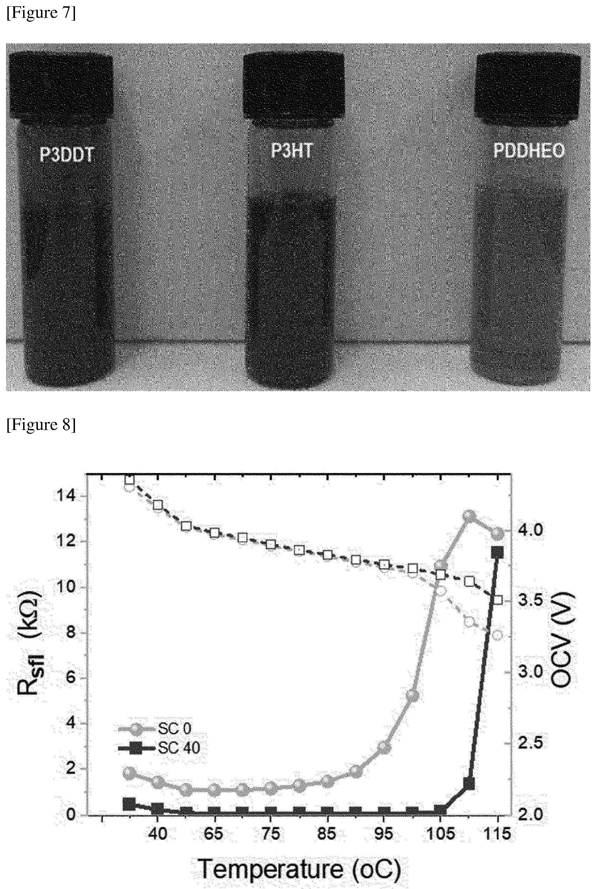

Figure 7 is photographs of a case where polythiophene is dispersed in toluene at a concentration of 3 weight%. In Figure 7, P3HT is polythiophene synthesized in the same manner as in Preparation Example 2, which is the result for polythiophene applying only 3-hexylthiophene as a monomer; P3DDT is polythiophene synthesized in the same manner as in Preparation Example 2, which is the result for polythiophene applying only 3-dodecylthiophene as a monomer; and PDDHEO is the result for polythiophene (A) prepared in Preparation Example 2. From the drawing, it can be confirmed that in the case of PDDHEO, the solution is relatively transparent, but P3DDT and P3HT are relatively opaque. Furthermore, in the case of the P3HT solution, the viscosity was about 15.1 cps (solubility in toluene: 1.04 weight%); in the case of the P3DDT solution, the viscosity was about 401 cps (solubility in toluene: 0.76 weight%); and in the case of the PDDHEO solution, the viscosity was about 4.5 cps (solubility in toluene: 9.0 weight%). From such results, it can be confirmed that when the conductive polymer disclosed herein is applied, the appropriate coating efficiency is secured, thereby providing properties suitable for mass production.

### Test Example 3.

Figure 8 shows EIS impedance plot results for polymer layers depending on temperatures. In Figure 8, SC0 is the result for the polymer layer of Example 1, and SC40 is the result for the polymer layer of Example 3. The solid line in Figure 8 is the change in EIS impedance for each case, and the dotted line is the change in OCV (Open Circuit Voltage) for each case.

From the drawing, it can be known that in the case of SC0, the PTC onset temperature is about 95°C or so, and in the case of SC40, the PTC onset temperature is about 105°C or so, and through this, it can be confirmed that the PTC onset temperature can be adjusted by introducing conductive particles. Furthermore, referring to the resistance increase rate, in the case of SC0, the rate was about 561 ohms·sec⁻¹, and in the case of SC40, the rate was about 1135 about 561 ohms·sec⁻¹ or so.

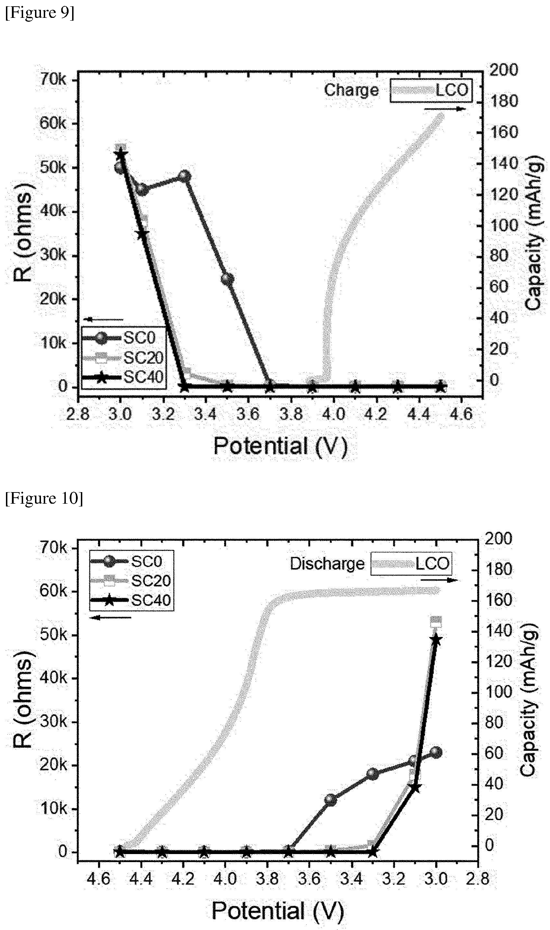

Figures 9 to 11 illustrate impedance results according to applied voltages.

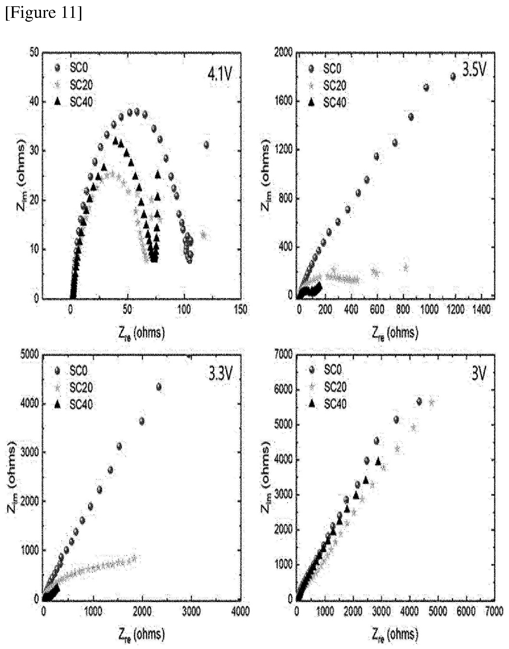

Figures 9 and 10 show EIS impedance changes relative to potentials in a range of 3V to 4.5 V, where Figure 9 simulates a charging process of a battery, and Figure 10 simulates a discharging process of a battery. In Figures 9 and 10, the curves indicated by LCO represent charge and discharge curves of a typical LCO positive electrode material. Figure 11 is EIS Nyquist plots at other applied voltages, which shows that as the voltage decreases, the resistance increases in the order of SC0 (Example 1), SC20 (Example 2), and SC40 (Example 3). In the case of SC40 (Example 3), its minimum resistance was maintained at 3.3V.

From the drawings, it can be known that upon charging, the resistance of SC40 decreases rapidly with increasing applied voltage, and in the case of SC0, insulator properties are maintained up to 3.6V. Similarly, it can be known that upon discharging, the resistance of SC0 (Example 1) begins to increase around 3.6V, and SC40 (Example 3) maintains it nearly constant on 3.2V. Such results mean that the resistance increase is more significant due to the presence of conductive particles, and this can effectively block the flow of current in the abnormal state.

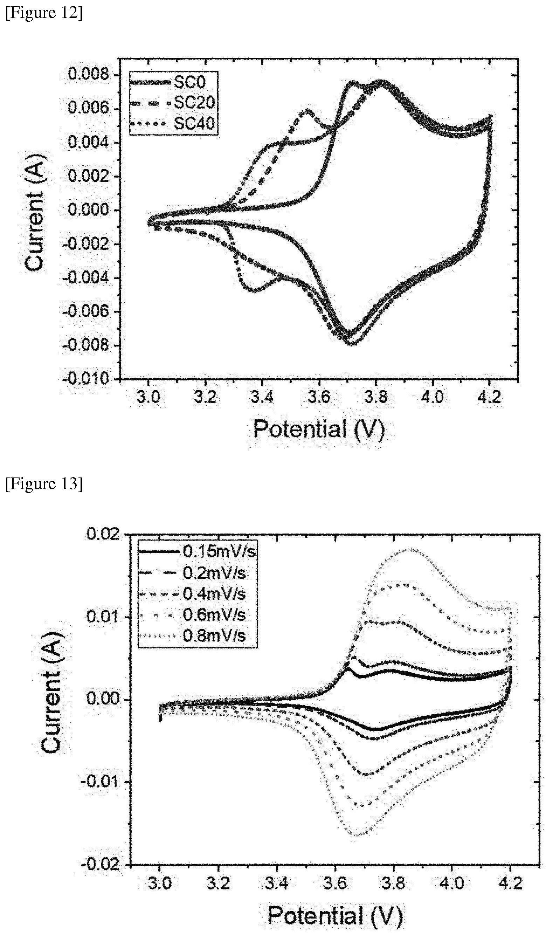

Figure 12 is CV (cyclic voltammetry) curves of SC0 (Example 1), SC20 (Example 2), and SC40 (Example 3) at a scan rate (sweep rate) of 0.4 mV/s. Typically, polythiophene exhibits two oxidation peaks. The polythiophene in a neutral state transitions to a polaron state and a bipolaron state upon oxidation by anion doping. The first oxidation peak of SC0 at 3.75 V shifted to 3.56 V or 3.41 V as the content of conductive particles increased, and the second oxidation peak remained at about 3.83 V. Additionally, it was the reversibility of the first oxidation improved by the addition of conductive particles.

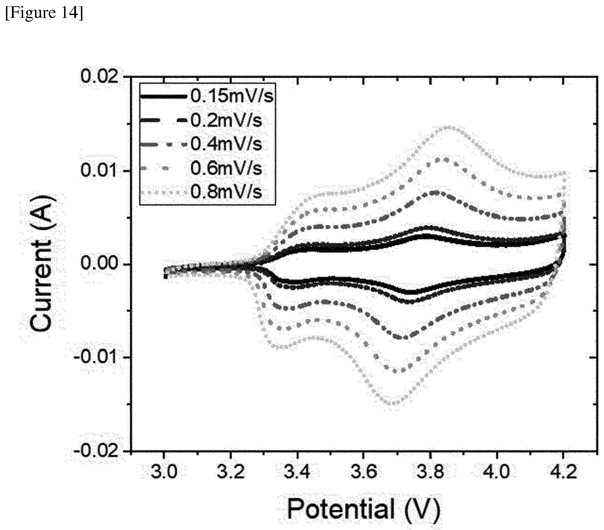

Figure 13 is CV (cyclic voltammetry) curves of SC0 (Example 1) according to scan rates (sweep rate) in a range of 0.15 mV/s to 0.8 mV/s, and Figure 14 is CV (cyclic voltammetry) curves of SC20 (Example 2) according to scan rates in a range of 0.15 mV/s to 0.8 mV/s. The reversibility of the first oxidation was improved by the addition of the conductive particles, which is distinguished from a gradual increase in the corresponding reduction peak current. The oxidation by anion doping at the low scan rate (0.15 mV/s, corresponding to 0.33C in galvanostatic cycling) occurred above 3.65 V, and in contrast to the corresponding CV curve of SC40 (Figure 14), the corresponding reduction peak was barely confirmed (Figure 13).

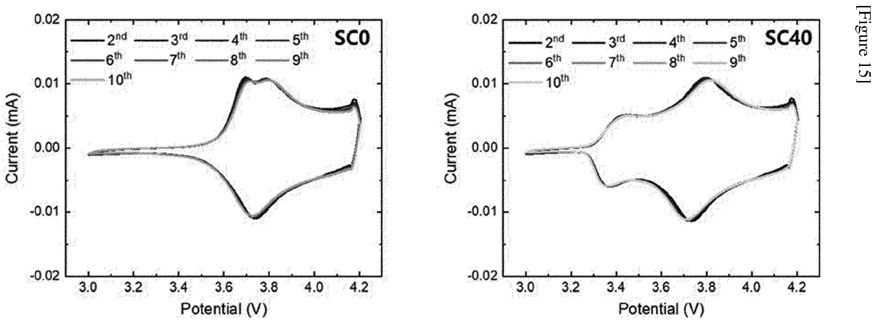

Figure 15 is CV curves of SC0 (Example 1) and SC40 (Example 3) according to cycles, where the CV curves between the 2nd and 10th cycles are nearly identical. From Figure 15, it can be confirmed that the redox peaks for multiple CV cycles are nearly constant, which means high electrochemical stability.

Such results mean that the conductive particles do not only simply increase conductivity, but also promote p-doping and ensure reversible de-doping through combination with specific conductive polymers.

### Test Example 4.

Capabilities of electrodes of Comparative Examples or Examples were compared through a galvanostatic cycling test increasing a C-rate from 0.1C to 2C. Such a test was performed on coin half cells manufactured using the electrodes. A separator and a lithium film were laminated on an electrode (Example: Al foil/polymer layer/active material layer, Comparative Example: Al foil/active material layer) of Examples or Comparative Examples to manufacture a laminate (Example: Al foil/polymer layer/active material layer/separator/lithium film, Comparative example: Al foil/active material layer/separator/lithium film), and the laminate was punched into a circle with a diameter of about 1.4 cm. A coin cell was manufactured by using a Wellcos CR2032 coin cell kit, and using the laminate punched into the circle and an electrolyte. Here, as the separator, a separator of W-SCOPE KOREA's WL20C model was used, and as the electrolyte, GTHR KOREA's electrolyte (1 M LiPF₆ solution, solvent = EC: DMC: DEC (3:3:4, volume ratio) (EC: Ethylene Carbonate, DMC: dimethyl carbonate, EMC: ethylmethyl carbonate)) (3 µL mAh⁻¹) was used, and as the lithium film, a film with a thickness of about 300 µm or so was used.

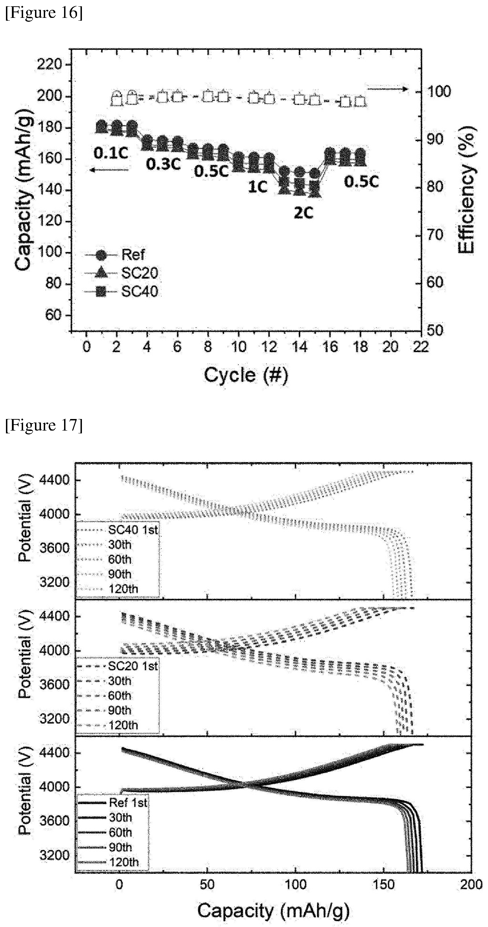

Figure 16 is results of performing the test on the coin half-cell. In Figure 6, the colored squares, circles, and triangles represent capacities, and the uncolored squares, circles, and triangles represent coulombic efficiencies. In Example 3 (SC40), the electrode resistance increased through the introduction of the polymer layer, but the initial discharge capacity was measured to be about 179.5 mAh/g, which means that the loss according to the introduction of the polymer layer is less than 1.2%. Even at 2C, the capacity difference was less than 2.2%.

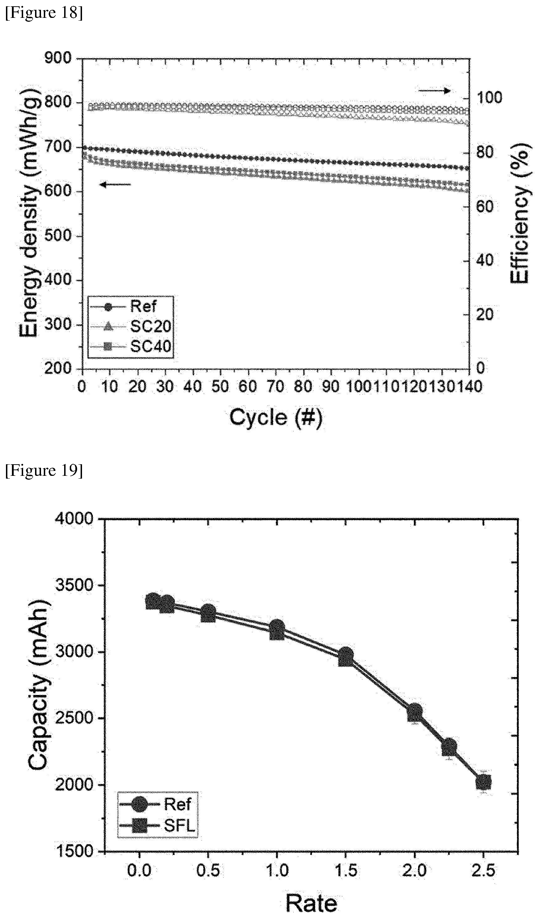

Figure 17 is charge-and-discharge profiles of a cycle test, and Figure 18 is energy density retention (140 cycles). Compared to Comparative Example 1 (Ref), the energy density retention in the case of Examples 2 and 3 was 92% and 95%, respectively.

A 3-Ah pouch cell was manufactured using the electrode of the Examples or Comparative Examples, and the electrochemical performance was evaluated.

A 3-Ah pouch cell using the electrode of Example 1 as the positive electrode and a 3-Ah pouch cell using the reference electrode as the positive electrode were each assembled.

The positive electrodes were each manufactured using the following method.

### <Electrode of Example>

Polymer layers were each formed on both surfaces of the same current collector as used in Example 3, in the same manner as in Example 3, and positive electrode active material layers were also formed on the relevant respective polymer layers, thereby manufacturing the electrode of Example. The positive electrode active material layers were formed to have a loading density of about 24.29 mg/cm or so and a porosity of about 3.99 g/cc or so.

A slurry comprising lithium cobalt oxide (LiCoO₂) (XTC), a carbon-based conductive agent (ECP (Ketjen Black) 0.5%, SFG (Trimrex graphite) 0.4%, DB (Denka Black) 0.4%), PVDF (polyvinylidene fluoride) (Kureha), and NMP (N-Methyl-2-pyrrolidone) in a weight ratio of 75:1:1:23 (LiCoO₂: conductive agent: PVDF: NMP) was applied to a polymer layer with a doctor blade to a thickness of about 90 µm or so, dried at room temperature (about 25°C), and then further dried under a vacuum condition at 120°C, and then rolled to produce the active material layer.

### <Reference electrode>

The positive electrode as the reference electrode was manufactured in the same manner as in the electrode of Example, but manufactured by forming the positive electrode active material layers on both surfaces of the current collector, respectively, without forming the polymer layer.

The negative electrode upon manufacturing the 3-Ah pouch cell was manufactured using the following method.

### <Negative electrode>

The negative electrode was manufactured by forming negative electrode active material layers on both sides of a Cu foil (copper foil) (thickness: about 8µm). The negative active material layer was formed to have a loading density of about 13.88 mg/cm or so and a porosity of about 1.75 g/cc or so. Water (I), SBR (Styrene-Butadiene rubber) (average particle diameter (D50 particle diameter): 150nm) (II), a thickener (CMC, carboxymethyl cellulose) (III), an electrode active material (1) (IV) (artificial graphite (GT), average particle diameter (D50 particle diameter): 20µm), and an electrode active material (2) (V) (natural graphite (PAS), average particle diameter (D50 particle diameter): 15 µm) were mixed in a weight ratio of 48.5:1:0.5:45:5 (I: II: III: IV: V) to prepare a slurry. The slurry was applied onto the surface of the Cu foil to a thickness of 280 µm or so by a gap coating method, dried at about 75°C for about 10 minutes, and then rolled to form the active material layer.

A stack cell was manufactured by laminating 14 negative electrodes and 13 positive electrodes (electrode of Example or reference electrode). A separator was positioned between the negative and positive electrodes. As the separator, a separator of W-SCOPE KOREA's WL20C model was used. A 3-Ah pouch cell was manufactured using the stack cell and an electrolyte. As the electrolyte, GTHR KOREA's electrolyte (1 M LiPF₆ solution, solvent = EC: DMC: DEC (3:3:4, volume ratio) (EC: ethylene carbonate, DMC: dimethyl carbonate, EMC: ethylmethyl carbonate)) (3 µL mAh-1) was used, and as the case, an envelope-type pouch (DNP, D-EL408PH(3)) was used. The pouch cell was manufactured to have horizontal and vertical dimensions of 50 mm and 90 mm, respectively.

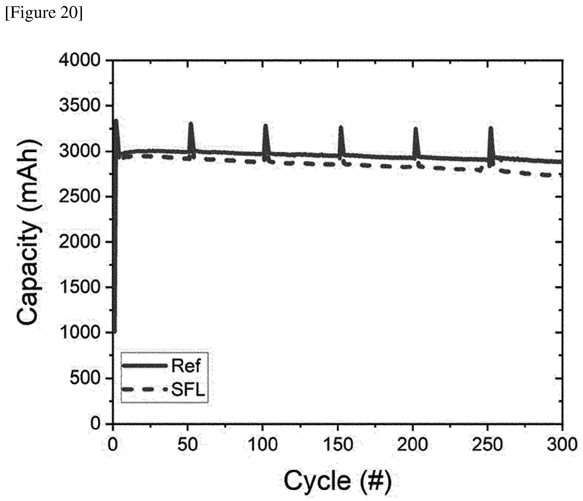

Figure 19 is rate test results of the 3-Ah pouch cell, and Figure 20 is cycle test results of the 3-Ah pouch cell (in the drawings, SFL is the case where the electrode of Example is applied, and Ref is the case where the reference electrode is applied). The capacity difference between Example 3 and Comparative Example 1 was less than 1.5% in the cycles from 0.1C to 2.5C. Furthermore, after 300 cycles, the capacity retention of Example above in the recovery cycle was 97%, which was equal to that of the reference electrode. Referring to such results, it can be confirmed that through the application of the polymer layer disclosed herein, it is possible to ensure stability in the abnormal state without adversely affecting battery operation in the normal state.

### Test Example 5.

An ARC (Accelerated Rate Calorimeter) test was performed using the following method. A 1-Ah pouch cell was manufactured, and the ARC test was performed thereon. The 1-Ah pouch cell was manufactured to have a width and a length of 30 mm and 42 mm, respectively.

As a positive electrode of the 1-Ah pouch cell, an electrode was used, in which an active material layer was formed on the polymer layer of the current collector manufactured in Example. The active material layers were formed to have a loading density of about 24.29mg/cm or so and a porosity of about 3.99 g/cc or so. Specifically, a slurry comprising lithium cobalt oxide (LiCoO₂) (XTC), a carbon-based conductive agent (ECP (Ketjen Black) 0.5%, SFG (Trimrex graphite) 0.4%, DB (Denka Black) 0.4%), PVDF (polyvinylidene fluoride) (Kureha), and NMP (N-Methyl-2-pyrrolidone) in a weight ratio of 75:1:1:23 (LiCoO₂: conductive agent: PVDF: NMP) was applied to the polymer layer of the current collector with a doctor blade to a thickness of about 90 µm or so, dried at room temperature (about 25°C), and then further dried under a vacuum condition at 120°C, and then rolled to produce an electrode. Upon manufacturing the electrode, the polymer layers were formed on both sides of the current collector body, and an active material layer was formed on each polymer layer.

The negative electrode of the 1-Ah pouch cell was used by forming a negative electrode active material layer on a Cu foil (thickness: about 8 µm) as the current collector so that the loading density was about 13.88 mg/cm or so and the porosity was about 1.75 g/cc or so. Water, SBR (Styrene-Butadiene rubber) binder (average particle diameter (D50 particle diameter): 150nm), a thickener (CMC, carboxymethyl cellulose), and an electrode active material (1) (artificial graphite (GT), average particle diameter (D50 particle diameter): 20µm), an electrode active material (2) (natural graphite (PAS), average particle diameter (D50 particle diameter): 15 µm) were mixed in a weight ratio of 48.5:1:0.5:45:5 (water: SBR: CMC: active material (1): active material (2)) to prepare a slurry, and the slurry was applied onto the surface of the current collector to a thickness of 280 µm or so by a gap coating method, and then dried at about 75°C for about 10 minutes, and rolled to form the active material layer. Upon manufacturing the electrode, the active material layer was formed on both sides of the current collector.

A 1100 mAh-stack cell was manufactured by laminating 6 negative electrodes and 7 positive electrodes. A separator was positioned between the negative and positive electrodes. As the separator, a separator of W-SCOPE KOREA's WL20C model was used. A 1-Ah pouch cell was manufactured using the stack cell and an electrolyte. As the electrolyte, GTHR KOREA's electrolyte (1 M LiPF₆ solution, solvent = EC: DMC: DEC (3:3:4, volume ratio) (EC: ethylene carbonate, DMC: dimethyl carbonate, EMC: ethylmethyl carbonate)) (3 µL mAh-1) was used, and as the case, an envelope-type pouch (DNP, D-EL408PH(3)) was used.

After charging the 1-Ah pouch cell up to 4.5 V at a rate of 0.1C, a thermocouple capable of measuring the temperature of the relevant cell was mounted on the 1-Ah pouch cell using an insulation Kapton tape. The 1-Ah pouch cell mounted with the thermocouple was placed in an ARC chamber (Yeonjin S-Tech, EV+ ARC), and the ARC test was performed using the standard Heat-Wait-Seek (HWS) method with setting an initial temperature to 50°C. While the temperature was increased at a temperature rise rate (exothermic limit) of 0.02°C/min, the heating was stopped if self-heating was confirmed in the 1-Ah pouch cell. The temperature change in this state was monitored and simultaneously the TR (thermal runaway) generation temperature and the maximum temperature were measured. The terminal temperature was set to 300°C for appropriate cooling of the ARC chamber. Here, the TR generation temperature was set to the temperature that the temperature change rate became 1°C/min.

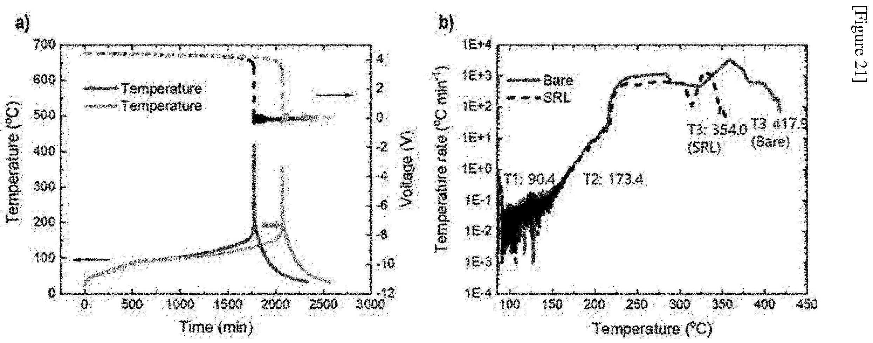

Figure 21 is results of the ARC test performed on a 1-Ah pouch cell (SRL) to which a current collector of Example is applied and a 1-Ah pouch cell (Bare) of Comparative Example. The Comparative Example is a 1-Ah pouch cell manufactured in the same manner as described above, but a case where an Al foil without forming any polymer layer is applied as the current collector for manufacturing the positive electrode. In Figure 21(a), the solid line is temperature changes, and the dotted line is voltage changes. Figure 21(b) is a graph of temperature vs. temperature change rate, and in the relevant graph, T1 is the temperature that self-heating is confirmed in the ARC test, T2 is the TR generation temperature, and T3 is the maximum temperature. As in the drawing, Example and Comparative Example had the same self-heating temperature and TR generation temperature of the 1-Ah pouch cell, but in the case of Example, it can be confirmed that TR generation is significantly delayed, and the maximum temperature was also confirmed to be lower in the case of Example. In the case of Example 1 and 2, the results like those of Example 3 were also confirmed.

### Test Example 6.

A 3500 mAh pouch cell was manufactured, and an impact test was performed in a state where the cell was at 100% SOC (state of charge). The 3500 mAh pouch cell was manufactured using the same method and materials as the manufacturing of the 3-Ah pouch cell in Test Example 4, except that only the number of stacks of positive and negative electrodes was changed.

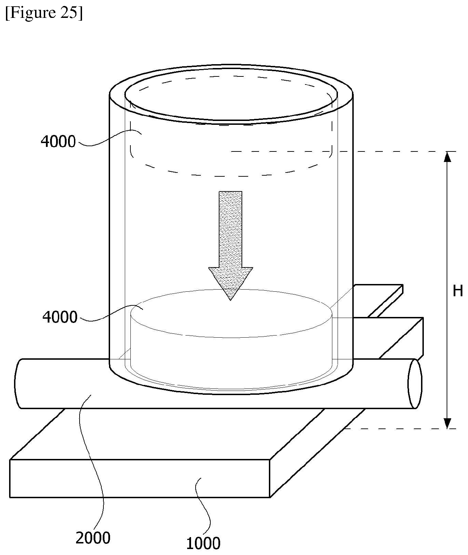

As shown in Figure 25, the 3500 mAh pouch cell (1000) was placed on a flat bottom, and a circular stainless-steel rod (2000) with a cross-section diameter of 2 cm or so was placed at the center of the pouch cell (1000). Subsequently, a cylindrical tube with an inner diameter of about 18.5 cm or so was fixed on the rod, and an iron impact weight (4000) with a diameter of about 18 cm or so and a mass of about 9.1 kg was freely dropped at a height (H) of 61 cm away from the pouch cell (1000) toward the center of the cell (1000), thereby performing the impact test. The impact weight was freely dropped once for each pouch cell (1000).

When the electrode of Comparative Example was introduced, 12 out of 19 cells exploded, whereas when the current collector of Example was applied, 17 out of 19 cells remained intact. Such results emphasize the important role of the polymer layer in improving battery stability. The non-exploded cells were disassembled and the condition of each component was investigated. Among the non-exploded cells, the positive electrodes (cathodes) and the negative electrodes (anodes) from the cells to which the electrode of Comparative Example was introduced were significantly burnt, and the separators were severely deformed. Conversely, in the case of non-exploded cells among the cells to which the electrode of Example was introduced, the respective components remained intact even after the external impact.

In situ temperature changes as measured using a TC (temperature controller) attached to an external surface of the cell were identified. If ignition occurred, the temperature rose rapidly, reaching up to 59°C/sec, due to cascade exothermic reactions between battery components. Even in the absence of explosion, the cell applying the electrode of Comparative Example experienced localized heating, which was attributed to structural deformation from the impact-induced intense current flow. The temperature rise in the cell introducing the electrode of Comparative Example and unexploded occurred 1.7 times faster than in the cell comprising the electrode introducing the corresponding polymer layer. Such results are adjusted to be consistent with the apparent structural deformation and contrasting temperature responses observed during the impact test, and are dependent on the inclusion of the polymer layer. Such contrasting results are attributed to the effective de-doping of the conductive polymer in the polymer layer under the increased voltage and temperature environments induced by internal shorting, and provide a mechanism for the instantaneous shutdown of localized current flow.

After the impact test, the pouch cell was disassembled, the positive electrode was separated therefrom, and then an XRF (X-ray fluorescence) analysis was performed on the positive electrode surface (active material layer surface). The analysis was performed using a Bruker Micro-XRF spectrometer, an X-ray tube was set to 5kV and 600 mA, and an Rh target was applied.

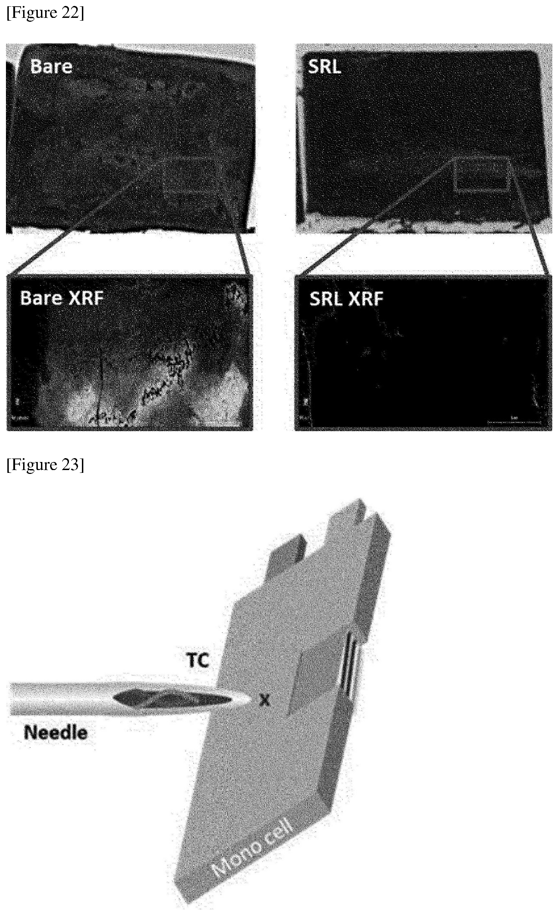

Figure 22 is XRF observation results for a positive electrode surfaces (active material layer surfaces) when the electrode of Example 3 was used (SRL, SRL XRF) and XRF observation results for a positive electrode surface (active material layer surface) when the electrode of Comparative Example was used (Bare, Bare XRF). The Comparative Example is a 3500 mAh pouch cell manufactured in the same manner as described above, except that an Al foil without forming any polymer layer is applied as the current collector for manufacturing the positive electrode.

As in the drawing, in the case of Comparative Example, a large amount of Cu migration from the negative electrode current collector was observed, but in the case of Example, almost no Cu migration was confirmed.

As a result of observing a 5cm x 5cm square area of each active material layer through the XRF device, in the case of Example, the Cu content was about 0.33 weight% or so (about 0.0132 weight% per unit area of 1cm²), and in the case of Comparative Example, the Cu content was about 10.15 weight% or so (about 0.406 weight% per unit area of 1cm²).

### Test Example 7.

A needle test for measuring a temperature surge within a battery by inserting a TC (temperature controller) inside a needle was performed.

A needle (TC-integrated needle) mounted with a TC (temperature controller) was manufactured with reference to a needle design reported in a literature (Huang, S. et al., Understanding Li-Ion Cell Internal Short Circuit and Thermal Runaway through Small, Slow, and In Situ Sensing Nail Penetration. J. Electrochem. Soc. 167, 090526 (2020)).

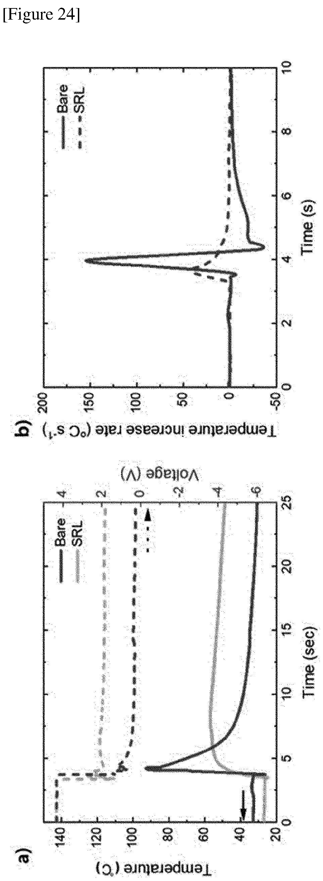

As shown in Figure 23, the needle was inserted into a mono-cell (electrode area: 30 mm × 42 mm) applying the positive electrode of Example above and the graphite-based negative electrode, and simultaneously the temperature change was measured. Figure 24 is results of the test.

In Figure 24, Bare is the results for a pouch cell applying the electrode of Comparative Example 1, and SRL is the results for a pouch cell applying the electrode of Example 3. The solid line in the drawing represents the temperature changes during the needle test, and the dotted line represents the voltage changes during the needle test. As shown in Figure 24 a), upon inserting the needle, the internal temperature of the cell in the case of Comparative Example (Bare) rose to 92°C, but in the case of Example (SRL), the internal temperature of the cell was maintained at 57°C or less. In the case of Comparative Example (Bare), the temperature rise rate of the cell was 154°C/sec, and in the case of Example (SRL), the temperature rise rate of the cell was 42°C/sec.

## Claims

1. A current collector comprising: a current collector body; and
a polymer layer formed on one or both sides of the current collector body, wherein
the polymer layer comprises a conductive polymer, and
the polymer layer exhibits a 2θ peak in a range of 3.4 degrees to 5 degrees in an XRD (X-ray diffraction) graph.

2. The current collector according to claim 1, wherein a d-spacing of a (100) plane in an XRD (X-ray diffraction) analysis is in a range of 1.8 to 2.6 nm.

3. The current collector according to claim 1, wherein a confirmation time point of an ARC (Accelerating Current Calorimetry) temperature change rate of 1°C/min is 30 hours or more.

4. The current collector according to claim 3, wherein a temperature at the confirmation time point of the ARC (Accelerating Current Calorimetry) temperature change rate of 1°C/min is 200°C or less.

5. The current collector according to claim 3, wherein an ARC (Accelerating Current Calorimeter) maximum temperature is 410°C or less.

6. The current collector according to claim 1, wherein a metal migration ratio in an impact test is 0.35 weight% or less per unit area of 1 cm².

7. The current collector according to claim 1, wherein a PTC onset temperature of the polymer layer is in a range of 70°C to 200°C.

8. The current collector according to claim 7, wherein a resistance increase rate after the PTC onset temperature is 400 ohm/sec or more.

9. The current collector according to claim 1, wherein the conductive polymer has a long-chain hydrocarbon functional group.

10. The current collector according to claim 9, wherein the conductive polymer contains, as the long-chain hydrocarbon functional group, a first hydrocarbon functional group with 10 or more carbon atoms and a second hydrocarbon functional group with 9 or less carbon atoms.

11. The current collector according to claim 10, wherein a ratio M₂/M₁ of a mole number M₂ of the second hydrocarbon functional group to a mole number M₁ of the first hydrocarbon functional group is in a range of 0.01 to 100.

12. The current collector according to claim 9, wherein the conductive polymer further contains a functional group of Formula 1 below: 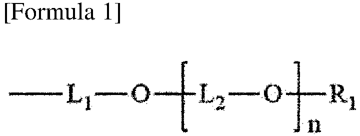 wherein, L₁ is a single bond, an alkylene group, or an alkylidene group, L₂ is an alkylene group or an alkylidene group, R₁ is hydrogen or an alkyl group, and m is a number in a range of 1 to 10.

13. The current collector according to claim 12, wherein a ratio M_{L}/M_{P} of a mole number M_{L} of the long-chain hydrocarbon functional group to a mole number M_{P} of the functional group of Formula 1 is in a range of 1 to 500.

14. The current collector according to claim 1, wherein the polymer layer further comprises a conductive material.

15. The current collector according to claim 14, wherein the conductive material is carbon particles, carbon fibers, graphene, graphite, carbon black, or carbon nanotubes.

16. An electrode comprising: the current collector of any one of claims 1 to 15; and
an active material layer formed on the polymer layer of the current collector.

17. The electrode according to claim 16, wherein the active material layer comprises a positive electrode active material.

18. An electrode assembly comprising the electrode of claim 16.

19. A secondary battery comprising the electrode of claim 16.

20. A secondary battery comprising the electrode assembly of claim 18.
